(19) Europäisches Patentamt
European Patent Office
Office européen des brevets

(11) Veröffentlichungsnummer : **0 401 167 B1**

(12) # EUROPÄISCHE PATENTSCHRIFT

(45) Veröffentlichungstag der Patentschrift : **08.06.94 Patentblatt 94/23**

(51) Int. Cl.[5] : **C07F 17/00,** C07F 7/28, C08F 2/50, G03F 7/027

(21) Anmeldenummer : **90810379.9**

(22) Anmeldetag : **23.05.90**

(54) **Verfahren zur Herstellung von Titanocenen mit o,o'- Difluorarylliganden.**

(30) Priorität : **01.06.89 CH 2053/89**

(43) Veröffentlichungstag der Anmeldung : **05.12.90 Patentblatt 90/49**

(45) Bekanntmachung des Hinweises auf die Patenterteilung : **08.06.94 Patentblatt 94/23**

(84) Benannte Vertragsstaaten : **BE CH DE FR GB IT LI NL**

(56) Entgegenhaltungen :
**JOURNAL OF ORGANOMETALLIC CHEMISTRY, Band 46, 1972, Lausanne J.H. TEUBEN & H.J. DE LIEFDE MEIJER "Synthesis and Properties ofAryldicyclopenta- dienyltitanium (III) Com- pounds" Seiten 313-321**
**JOURNAL OF ORGANOMETALLIC CHEMISTRY, Band 74, 1974, Lausanne M.D. RAUSCH & H.B. GORDON "The Preparation and Properties of someAlkyl and Aryl Derivatives of Titanium" Seiten 85-90**
**JOURNAL OF ORGANOMETALLIC CHEMISTRY, Band 4, 1965, Amsterdam C. TAMBORSKI "Pentathoro- phenyl Organometallic Compounds of Group IV Elements" Seiten446-454**

(73) Patentinhaber : **CIBA-GEIGY AG**
**Klybeckstrasse 141**
**CH-4002 Basel (CH)**

(72) Erfinder : **Desobry, Vincent, Dr.**
**Route du Confin 50**
**CH-1723 Marly (CH)**

**EP 0 401 167 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein verbessertes Verfahren zur Herstellung von Titanocenen mit o,o'-Difluorarylliganden.

Es ist bekannt, Titanocene mit polyfluorierten Arylliganden herzustellen aus den entsprechenden fluorierten Aryllithium-Verbindungen und einem Titanocendihalogenid. Die Aryllithium-Verbindung kann - ohne isoliert zu werden - aus dem entsprechenden Polyfluorbenzol und Butyllithium hergestellt werden, wobei ein Wasserstoffatom, das in Nachbarstellung zu zwei Fluoratomen steht, durch Lithium ersetzt wird. Tamborski et al., J. Organomet. Chem. 4 (1965), 446-454 haben diese Reaktionsfolge an Hand der Herstellung von Bis(cyclopentadienyl)-bis(pentafluorphenyl)-titan gezeigt:

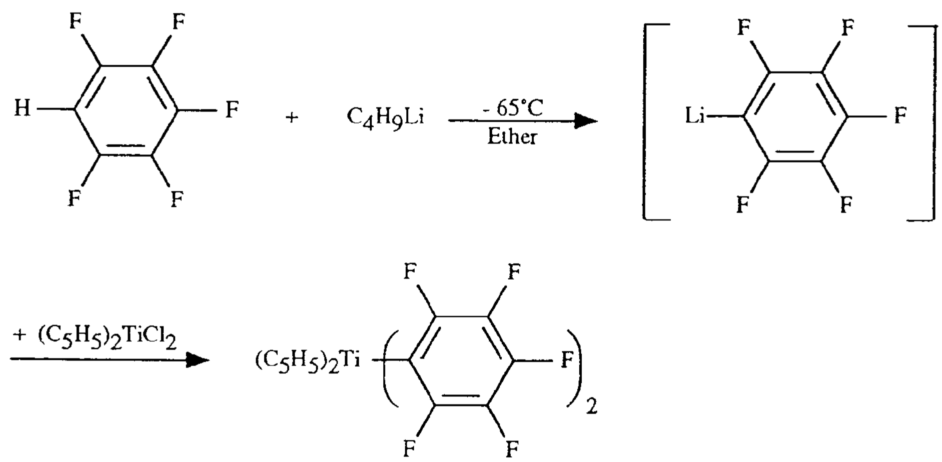


Die Bildung des Pentafluorphenyllithium muss bei sehr niedrigen Temperaturen erfolgen, da diese Verbindung bei Raumtemperatur instabil ist und sich bereits bei -10°C rasch zersetzt, wie bereits Coe et al., J. Chem. Soc. 1962, 3227, gezeigt haben.

Eine Reaktion bei so niedrigen Temperaturen bedeutet für eine industrielle Anwendung einen hohen Energiebedarf für die Kühlung des Reaktionsmediums. Es wurde jedoch nunmehr gefunden, dass die Reaktion bzw. Reaktionsfolge bei wesentlich höheren Temperaturen ausgeführt werden kann, wenn man die Metallierung des Polyfluorarens mit einem Lithiumamid durchführt in Anwesenheit des Reaktionspartners Titanocendihalogenid. Dies ist überraschend, da man unter diesen Bedingungen eine Amidierung des Titanocens erwartet. Die Reaktion erwies sich anwendbar auf eine Vielzahl von Fluorarenen, sofern diese mindestens 2 Fluoratome in 1,3-Stellung besitzen. Die Metallierung erfolgt dann in der 2-Stellung. In den übrigen Positionen des Arens können Wasserstoff, Alkyl oder Fluor stehen oder solche funktionelle Gruppen, die mit dem Lithiumamid oder dem Lithiumaren nicht reagieren.

Gegenstand der Erfindung ist daher ein Verfahren zur Herstellung von Titanocenen der Formel I,

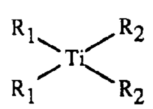

I

worin $R_1$ unsubstituiertes oder ein- oder mehrfach durch $C_1$-$C_{18}$-Alkyl, $C_1$-$C_{18}$-Alkoxy, $C_2$-$C_{18}$-Alkenyl, $C_5$-$C_8$-Cycloalkyl, $C_6$-$C_{10}$-Aryl, $C_7$-$C_{16}$-Aralkyl, $-Si(R_3)_3$, $-Ge(R_3)_3$ oder Halogen substituiertes Cyclopentadienyl$^{\ominus}$, Indenyl$^{\ominus}$ oder 4,5,6,7-Tetrahydroindenyl$^{\ominus}$ bedeutet oder beide $R_1$ zusammen einen zweiwertigen Rest der Formel II bedeuten,

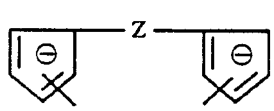

II

worin Z $-(CH_2)_m-$ mit m = 1, 2 oder 3, gegebenenfalls mit Phenyl substituiertes $C_2$-$C_{12}$-Alkyliden, $-Si(R_3)_2-$ oder $-Si(R_3)_2-O-Si(R_3)_2-$ bedeutet und

$R_3$ $C_1$-$C_{12}$-Alkyl oder $C_6$-$C_{10}$-Aryl bedeutet,
$R_2$ einen sechsgliedrigen carbocyclischen aromatischen Ring bedeutet, der in beiden Orthopositionen zur Ti-C-Bindung mit Fluor substituiert ist und der ausserdem durch weitere Fluoratome, durch $C_1$-$C_4$-Alkyl oder durch eine der Gruppen III bis VII substituiert sein kann,

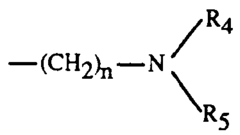 III, 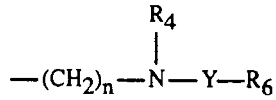 IV, 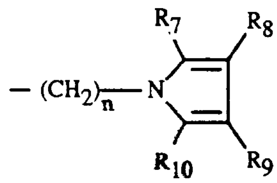 V,

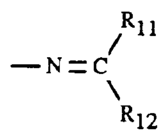 VI,

$-O-R_{13}$ VII

worin n eine ganze Zahl von 0 bis 6 bedeutet,
$R_4$ $C_1$-$C_{20}$-Alkyl, $C_3$-$C_{10}$-Cycloalkyl, $C_4$-$C_{20}$-Cycloalkylalkyl, $C_4$-$C_{20}$-Alkylcycloalkyl, $C_5$-$C_{20}$-Alkylcycloalkylalkyl, $C_6$-$C_{14}$-Aryl, $C_7$-$C_{20}$-Aralkyl, $C_7$-$C_{20}$-Alkaryl, $C_8$-$C_{20}$-Alkaralkyl, $C_3$-$C_{12}$-Alkoxyalkyl, Tetrahydrofurfuryl oder einen Rest $-(CH_2CH_2O)_p$-$C_1$-$C_{12}$-Alkyl mit p = 1-20 bedeutet,
$R_5$ eine der für $R_4$ gegebenen Bedeutungen hat oder $R_4$ und $R_5$ zusammen $C_3$-$C_8$-Alkylen bedeuten, das durch -O-, -S- oder $-N(R_{14})$- unterbrochen sein kann, oder $R_4$ und $R_5$ zusammen $-Si(R_3)_2-CH_2CH_2-Si(R_3)_2$- bedeuten,
Y -CO-, -CS-, -COO-, $-CON(R_{14})$-, $-SO_2$-, $-SO_2N(R_{14})$- oder $-Si(R_3)_2$- bedeutet, $R_6$ $C_4$-$C_{20}$-Alkyl, $C_2$-$C_{20}$-Alkaryl, $C_4$-$C_{10}$-Cycloalkyl, $C_5$-$C_{20}$-Cycloalkylalkyl, $C_5$-$C_{20}$-Alkylcycloalkyl, $C_6$-$C_{20}$-Alkylcycloalkylalkyl, $C_6$-$C_{14}$-Aryl, $C_7$-$C_{20}$-Aralkyl, $C_7$-$C_{20}$-Alkaryl oder $C_8$-$C_{20}$-Alkarylalkyl bedeutet, wobei diese Reste unsubstituiert oder durch $C_1$-$C_{18}$-Alkoxy, $C_1$-$C_{18}$-Alkylthio oder Halogen substituiert sein können,
oder $R_5$ und $R_4$ zusammen $C_4$-$C_8$-Alkylen bedeuten, das durch -O-, -S- oder $-N(R_{14})$-unterbrochen sein kann,
mit der Bedingung, dass das zu Y benachbarte C-Atom von $R_5$ kein H-Atom trägt, wenn Y -CO-, -CS- oder $-SO_2$- ist,
$R_7$, $R_8$, $R_9$ und $R_{10}$ unabhängig voneinander Wasserstoff, unsubstituiertes oder durch $C_2$-$C_8$-Dialkylamino, Bis[2-($C_1$-$C_4$-alkoxy)-ethyl]amino, Morpholino, Piperidino, $C_2$-$C_{12}$-Alkoxy, $-(OCH_2CH_2)_p$-O-$C_1$-$C_{12}$-Alkyl mit p = 1-20, 1,3-Dioxolan-2-yl, $C_1$-$C_{12}$-Alkylthio oder Halogen substituiertes $C_1$-$C_{18}$-Alkyl, $C_2$-$C_5$-Alkenyl, $C_7$-$C_9$-Phenylalkyl oder $C_7$-$C_{12}$-Alkylphenyl bedeuten, oder 2-Furyl oder $-Si(R_3)_3$ bedeuten,
$R_{11}$ unsubstituiertes oder durch Halogen, $C_1$-$C_{12}$-Alkoxy oder $C_2$-$C_8$-Dialkylamino substituiertes $C_1$-$C_{12}$-Alkyl, unsubstituiertes oder durch $C_1$-$C_8$-Alkoxy, $-(OCH_2CH_2)_p$-O-$C_1$-$C_{12}$-Alkyl mit p = 1-20, $C_1$-$C_8$-Alkylthio, $C_2$-$C_8$-Dialkylamino, Halogen oder Nitro substituiertes $C_6$-$C_{14}$-Aryl, $C_7$-$C_{20}$-Aralkyl, $C_7$-$C_{20}$-Alkaryl oder $C_8$-$C_{20}$-Alkarylalkyl bedeutet,
$R_{12}$ Wasserstoff ist oder eine der für $R_{11}$ gegebenen Bedeutungen hat,
$R_{13}$ $C_1$-$C_{18}$-Alkyl, $C_3$-$C_{12}$-Cycloalkyl, $C_2$-$C_5$-Alkenyl, Glycidyl, $-(CH_2CH_2O)_p$-$C_1$-$C_{12}$-Alkyl mit p = 1-20, $C_6$-$C_{10}$-Aryl, $C_7$-$C_{20}$-Aralkyl, $C_7$-$C_{20}$-Alkaryl, $C_8$-$C_{20}$-Alkarylalkyl bedeutet, wobei die Arylreste durch $C_1$-$C_4$-Alkoxy, $C_1$-$C_4$-Alkylthio, $C_2$-$C_8$-Dialkylamino, Halogen oder Nitro substituiert sein können, oder $R_{13}$ $C_1$-$C_{20}$-Halogenalkyl, $-Si(R_3)_3$, $-Sn(R_3)_3$ oder 2-Tetrahydropyranyl bedeutet und
$R_{14}$ $C_1$-$C_{12}$-Alkyl, $C_3$-$C_5$-Alkaryl oder $C_7$-$C_9$-Phenylalkyl bedeutet, durch Umsetzung einer Verbindung der Formel VIII,

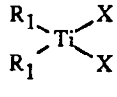 VIII

worin X Cl, Br oder J bedeutet, mit $LiR_2$, dadurch gekennzeichnet, dass man ein Gemisch von 1 Mol-Aequivalent der Verbindung der Formel VIII und 2 Mol-Aequivalenten einer Verbindung $HR_2$ mit 2 bis 2,5 Mol-Aequivalenten eines Lithiumamides bei -30°C bis +25°C in einem inerten Lösungsmittel umsetzt,
wobei das Lithiumamid eine Verbindung der Formel $LiN(R_{15})(R_{16})$ ist, worin $R_{15}$ und $R_{16}$ unabhängig voneinander in 1-Stellung verzweigtes Alkyl, Cyclohexyl oder Phenyl bedeuten oder $R_{15}$ und $R_{16}$ zusammen mit dem

H-Atom ein 2,5-dialkyliertes Pyrrolidin oder ein 2,6-dialkyliertes oder 2,2,6,6-tetraalkyliertes Piperidin bedeutet.

Die Reaktion wird vorzugsweise bei -20°C bis +25°C; insbesondere bei -15°C bis 0°C ausgeführt.

Vorzugsweise verwendet man pro Mol-Aequivalent der Verbindung der Formel VIII 2,0 bis 2,2 Mol-Aequivalente des Lithiumamides.

Wie bei allen Reaktionen mit lithiumorganischen Verbindungen sollen die verwendeten Lösungsmittel trocken sein und es empfiehlt sich die Verwendung eines Schutzgases, z.B. Stickstoff oder Argon. Zur Beschleunigung der Reaktion und zur Erhöhung der Ausbeute arbeitet man vorzugsweise in Gegenwart eines polaren Lösungsmittels, vor allem in Gemischen von polaren und unpolaren Lösungsmitteln. Verwendbare unpolare Lösungsmittel sind vor allem Kohlenwasserstoffe, wie Alkane, Cyclohexan, Benzol oder Toluol. Verwendbare polare Lösungsmittel sind vor allem Ether, wie z.B. Diethyl- oder Diisopropylether, tert.Butylmethylether, Anisol, Ethylenglykol- oder Diethylenglykol-dialkylether, Tetrahydrofuran oder Dioxan, aber auch voll alkylierte Amide, wie z.B. Tetramethylharnstoff, Hexamethylphosphorsäuretriamid oder N,N'-Dimethylimidazolidinon-2. Besonders geeignet sind Gemische von Toluol und Tetrahydrofuran oder Hexan und Tetrahydrofuran im annähernden Volumenverhältnis von 1:1.

Die Lithiumamide $LiN(R_{15})(R_{16})$ können z.B. durch Umsetzung des entsprechenden sekundären Amins $HN(R_{15})(R_{16})$ mit Butyllithium oder mit Lithiummetall in Gegenwart von Naphthalin oder Styrol hergestellt werden, siehe V. Schöllkopf in Methoden der Organischen Chemie, Band XIII/1, Seite 98, G. Thieme-Verlag 1970. Einzelne Lithiumamide, wie z.B. Lithium-diisopropylamid, sind im Handel erhältlich. Man kann die Lithiumamide auch in situ in der Reaktionsmischung des erfindungsgemässen Verfahrens, vorteilhaft vor der Zugabe der bzw. zu den Edukte(n) I und VIII, aus den vorstehend genannten Komponenten herstellen. Siehe dazu auch Beispiel 1.

Bevorvorzugt verwendet man als Lithiumamid das Lithium-diisopropylamid, -cyclohexyl-isopropylamid, -dicyclohexylamid und -2,2,6,6-tetramethylpiperidid, insbesondere das Lithium-diisopropylamid.

Als Verbindung der Formel VIII verwendet man vorzugsweise eine solche, worin X Chlor ist. Bevorzugt verwendet man eine Verbindung der Formel VIII, worin $R_1$ Cyclopentadienyl$^{\ominus}$ oder durch $C_1$-$C_4$-Alkyl substituiertes Cyclopentadienyl$^{\ominus}$ bedeutet, insbesondere Cyclopentadienyl$^{\ominus}$ oder Methylcyclopentadienyl$^{\ominus}$. Beispiele für Verbindungen der Formel VIII sind Dicyclopentadienyltitandichlorid und Di(methylcyclopentadienyl)titandichlorid.

Als Verbindung $HR_2$ verwendet man bevorzugt eine solche, worin $R_2$ ein einwertiger Rest der Formel IX ist,

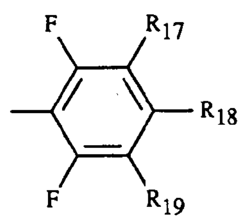

IX

worin $R_{17}$, $R_{18}$ und $R_{19}$ unabhängig voneinander Wasserstoff, Fluor, $C_1$-$C_4$-Alkyl oder eine Gruppe der Formel III bis VII bedeuten.

Hierzu gehören solche Verbindungen $HR_2$, worin $R_2$ ein Rest der Formel IX ist, worin $R_{17}$, $R_{18}$ und $R_{19}$ unabhängig voneinander H, F oder $CH_3$ bedeuten. Beispiele hierfür sind 1,3-Difluorbenzol, 1,3,4-Trifluorbenzol, 1,2,4,5-Tetrafluorbenzol, Pentafluorbenzol oder 2,4-Difluortoluol.

Eine andere Gruppe von Verbindungen $HR_2$ sind solche, worin $R_2$ ein Rest der Formel IX ist, worin $R_{17}$ oder $R_{18}$ eine Gruppe der Formel III bis VII ist und die anderen Reste $R_{17}$, $R_{18}$ und $R_{19}$ H oder F bedeuten. Unter diesen Verbindungen $HR_2$ sind solche bevorzugt, worin $R_{17}$ oder $R_{18}$ eine Gruppe der Formel III bis VII ist, worin n 0 oder 1 ist, insbesondere 0 ist,

$R_4$ $C_1$-$C_{12}$-Alkyl, $C_3$-$C_{12}$-Alkoxy, Phenyl, $C_7$-$C_9$-Phenylalkyl, Cycloalkyl, Cyclohexylmethyl oder eine Gruppe $-(CH_2CH_2O)_p$-$C_1$-$C_4$-Alkyl mit p = 1-5 bedeutet,

$R_5$ eine der für $R_4$ gegebenen Bedeutungen hat oder $R_4$ und $R_5$ zusammen $C_4$-$C_5$-Alkylen bedeuten, das durch -O- oder $-N(R_{14})$- unterbrochen sein kann, wobei $R_{14}$ $C_1$-$C_4$-Alkyl bedeutet,

Y -CO-, $-SO_2$-oder -COO- bedeutet,

$R_6$ $C_4$-$C_{12}$-Alkyl, Phenyl oder durch $CH_3$, $CH_3O$ oder Cl substituiertes Phenyl oder $C_1$-$C_8$-Halogenalkyl bedeutet oder $R_6$ und $R_4$ zusammen $C_4$-$C_8$-Alkylen bedeuten, mit der Bedingung, dass das zu Y benachbarte C-Atom von $R_5$ kein H-Atom trägt,

$R_7$, $R_8$, $R_9$ und $R_{10}$ unabhängig voneinander Wasserstoff, $C_1$-$C_8$-Alkyl, $C_2$-$C_{12}$-Alkoxyalkyl, $C_2$-$C_4$-Alkenyl, Phenyl oder 2-Furyl bedeuten,

$R_{11}$ unsubstituiertes oder durch $C_1$-$C_{12}$-Alkyl, $C_1$-$C_4$-Alkoxy, $C_1$-$C_4$-Alkylthio, Halogen oder Nitro substituiertes Phenyl bedeutet, $R_{12}$ Wasserstoff ist und

$R_{13}$ $C_1$-$C_{14}$-Alkyl, $-(CH_2CH_2O)_p$-$C_1$-$C_{12}$-Alkyl mit p = 1-20, Phenyl, Benzyl, 2-Tetrahydropyranyl oder $-Si(CH_3)_3$ bedeutet.

Bevorzugt verwendet man Verbindungen $HR_2$, worin $R_2$ ein Rest der Formel IX ist, worin entweder $R_{17}$ eine Gruppe der Formel III-VII ist und $R_{18}$ und $R_{19}$ Wasserstoff sind, oder worin $R_{18}$ eine Gruppe der Formel III-VII ist und $R_{17}$ und $R_{19}$ Fluor sind.

Beispiele solcher Verbindungen $HR_2$ sind:

1,2,4,5-Tetrafluor-3-(dimethylamino)-benzol
1,2,4,5-Tetrafluor-3-morpholinobenzol
1,2,4,5-Tetrafluor-3-decyloxybenzol
1,3-Difluor-4-(dimethylaminomethyl)-benzol
1,3-Difluor-4-decyloxybenzol
1,3-Difluor-4-ethoxybenzol
1,3-Difluor-4-(2-ethoxy)ethoxybenzol
N-(2,4-Difluorphenyl)-N-hexyl-α,α-dimethylbuttersäureamid
N-(2,4-Difluorphenyl)-N-isopropyl-benzamid
N-(2,4-Difluorphenyl)-N-(3-phenylpropyl)-pivalinamid
N-(2,4-Difluorphenyl)-N-hexyl-pivalinamid
N-(2,4-Difluorphenyl)-N-hexyl-α,α-dimethylvalerianamid
N-(2,4-Difluorphenyl)-N-butyl-α,α-dimethylvalerianamid
N-(2,4-Difluorphenyl)-N-ethyl-propionamid
N-(2,4-Difluorphenyl)-N-ethyl-isobuttersäureamid
N-(2,4-Difluorphenyl)-N-cyclohexyl-benzamid
N-(2,4-Difluorphenyl)-N-butyl-p-toluolsulfonamid
N-(2,4-Difluorphenyl)-3,3-dimethylazetidin-2-on
N-(2,4-Difluorphenyl)-pyrrol
N-(2,4-Difluorbenzyl)-pyrrol
1-(2,4-Difluorphenyl)-2,5-dimethylpyrrol
1-(2,4-Difluorphenyl)-2,2,5,5-tetramethyl-1,2,5-azadisilolidin
1-[(2,4-Difluorphenyl)methyl]-2,2,5,5-tetramethyl-1,2,5-azadisilolidin
N-(2,3,5,6-Tetrafluorphenyl)-pyrrol
N-(2,3,5,6-Tetrafluorbenzyl)-pyrrol
N-(2,3,5,6-Tetrafluorphenyl)-N-hexyl-α,α-dimethylvalerianamid
N-(3,5-Difluorphenyl)-pyrrol
N-Benzal-2,4-difluoranilin
N-(4-Methylbenzal)-2,4-difluoranilin
N-(4-Methoxybenzal)-2,4-difluoranilin
1,3-Difluor-4-butoxybenzol
1,3-Difluor-4-(trimethylsiloxy)-benzol
1,3-Difluor-4-(2-tetrahydropyranyl)-benzol
1,2,4,5-Tetrafluor-3-ethoxybenzol
1,2,4,5-Tetrafluor-3-dodecyloxybenzol
1,2,4,5-Tetrafluor-3-[2-(2-butoxy)-ethoxy]-ethoxybenzol
1-(2,3,5,6-Tetrafluorphenyl)-2,5-dimethylpyrrol

Die Herstellung der Azomethin-Edukte ist dem Fachmann geläufig und in zahlreichen Lehrbüchern der Organischen Chemie beschrieben. So lassen sich die Azomethin-Edukte der vorliegenden Erfindung beispielsweise durch Umsetzung der entsprechenden primären Amine mit Aldehyden herstellen.

Zur Ausführung des Verfahrens ist es vorteilhaft, eine Lösung des Lithiumamides zu einer Suspension oder Lösung der Verbindung der Formel VIII und der Verbindung $HR_2$ unter Kühlung und unter Rühren zuzutropfen. Die Reaktion verläuft rasch und kann durch analytische Bestimmung des Lithiumamides oder der Edukte verfolgt werden.

Zur Abtrennung des gebildeten Lithiumhalogenides LiX kann man das Reaktionsgemisch auf Wasser giessen und mit einem organischen Lösungsmittel extrahieren. Oder man dampft das Reaktionsgemisch teilweise oder ganz ein und extrahiert den Rückstand mit einem organischen Lösungsmittel, in dem LiX unlöslich ist, beispielsweise mit Dichlormethan. Das durch Eindampfen der organischen Lösung erhaltene Rohprodukt kann

durch Kristallisation oder Chromatographie gereinigt werden.
Die Produkte der Formel I sind orangerot gefärbte Verbindungen, die bei Raumtemperatur unter Ausschluss von kurzwelligem Licht beständig sind. Sie können als Photoinitiatoren zur Photopolymerisation ethylenisch ungesättigter Verbindungen verwendet werden. Ein Teil dieser Titanocene der Formel I sind bekannte Verbindungen und sind z.B. in den EP-A-122 223, 255 486 und 256 981 beschrieben. Ein Teil der Produkte sind neue Verbindungen.

Die Verbindungen der Formel I können als Photoinitiatoren für die Photopolymerisation ethylenisch ungesättigter Verbindungen verwendet werden. Detaillierte Angaben über die Verwendung von Titanocenen als Photoinitiatoren können der EP-A-0 318 894 entnommen werden. Die Verbindungen der Formel I können analog verwendet werden. Die Verbindungen der Formel I, worin $R_2$ mit einer Grüppe VI substituiert ist, stellen wichtige Zwischenprodukte für die Herstellung von Titanocenen mit fluorierten Aminoarylliganden dar, welche sich nicht auf direktem Wege herstellen lassen. Die Gruppe der Formel VI lässt sich durch saure Hydroylyse in die $NH_2$-Gruppe verwandeln, ohne dass eine hydrolytische Spaltung der Titan-Kohlenstoff-Bindung eintritt. Nachfolgeprodukte des Bis(cyclopentadienyl)-bis-(2,6-difluor-3-aminophenyl)-titans werden in der EP-A-0 318 894 in grosser Zahl beschrieben.

Ein weiterer Gegenstand der Erfindung ist ein Verfahren zur Herstellung von Titanocenen der Formel X

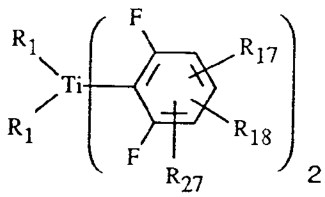

(X),

worin $R_1$ unsubstituiertes oder ein- oder mehrfach durch $C_1$-$C_{18}$-Alkyl, $C_1$-$C_{18}$-Alkoxy, $C_2$-$C_{18}$-Alkenyl, $C_5$-$C_8$-Cycloalkyl, $C_6$-$C_{10}$-Aryl, $C_7$-$C_{16}$-Aralkyl, $-Si(R_3)_3$, $-Ge(R_3)_3$ oder Halogen substituiertes Cyclopentadienyl$^{\ominus}$, Indenyl$^{\ominus}$ oder 4,5,6,7-Tetrahydroindenyl$^{\ominus}$ bedeutet oder beide $R_1$ zusammen einen zweiwertigen Rest der Formel II bedeuten,

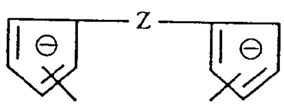

II

worin Z $-(CH_2)_m-$ mit m = 1, 2 oder 3, gegebenenfalls mit Phenyl substituiertes $C_2$-$C_{12}$-Alkyliden, $-Si(R_3)_2-$ oder $-Si(R_3)_2-O-Si(R_3)_2-$ bedeutet und
$R_3$ $C_1$-$C_{12}$-Alkyl oder $C_6$-$C_{10}$-Aryl bedeutet,
$R_{17}$ und $R_{18}$ unabhängig voneinander Wasserstoff, Fluor oder $C_1$-$C_4$-Alkyl, und $R_{27}$ $-NH_2$ oder eine Gruppe der Formel XI oder XIa bedeuten

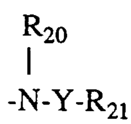

(XI)

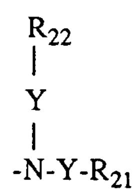

(XIa)

worin $R_{20}$ Wasserstoff, lineares oder verzweigtes $C_1$-$C_{20}$-Alkyl, $C_2$-$C_{20}$-Alkenyl, $C_3$-$C_8$-Cycloalkyl, $C_4$-$C_{20}$-Cycloalkylalkyl oder -Alkylcycloalkyl, $C_5$-$C_{20}$-Alkylcycloalkylalkyl, $C_6$-$C_{20}$-Cycloalkenylalkyl, $C_6$-$C_{14}$-Aryl, $C_7$-$C_{20}$-Aralkyl oder -Alkaryl, $C_8$-$C_{20}$-Alkaralkyl oder $C_3$-$C_{12}$-Trialkylsilyl darstellt, wobei diese Reste unsubstituiert oder durch $C_1$-$C_{18}$-Alkoxy, $C_1$-$C_{18}$-Alkylthio, $C_1$-$C_{18}$-Alkylsulfonyl, $C_6$-$C_{10}$-Arylsulfonyl, $C_7$-$C_{20}$-Alkarylsulfonyl, 2-Tetrahydrofuranyl oder Cyano substituiert sind,
$R_{21}$ eine der für $R_{20}$ gegebenen Bedeutungen hat oder $C_1$-$C_{20}$-Halogenalkyl, durch -CO-unterbrochenes $C_2$-

$C_{20}$-Alkyl oder durch -COOH oder -$COOR_{23}$ substituiertes $C_1$-$C_{12}$-Alkyl ist, worin $R_{23}$ $C_1$-$C_{12}$-Alkyl, $C_5$-$C_{12}$-Cycloalkyl, $C_6$-$C_{16}$-Aryl oder $C_7$-$C_{16}$-Aralkyl ist, und im Falle, dass Y -CO-, -CS- oder -$SO_2$- ist, auch -$NR_{24}R_{25}$ bedeuten kann, worin $R_{24}$ und $R_{25}$ unabhängig voneinander eine der für $R_{20}$ gegebenen Bedeutungen haben oder $R_{24}$ und $R_{25}$ zusammen $C_3$-$C_7$-Alkylen bedeuten, das durch -O-, -S- oder -N($R_{26}$)- unterbrochen werden kann, worin $R_{26}$ Wasserstoff, $C_1$-$C_{12}$-Alkyl, $C_3$-$C_{12}$-Alkenyl, $C_7$-$C_{12}$-Aralkyl oder $C_2$-$C_{20}$-Alkanoyl bedeutet, oder $R_{20}$ und $R_{21}$ zusammen lineares oder verzweigtes $C_2$-$C_8$-Alkylen oder durch Halogen, $C_1$-$C_4$-Alkoxy, Allyloxy oder -$NR_{24}R_{25}$ substituiertes $C_2$-$C_8$-Alkylen oder einen zweiwertigen Rest der Formel

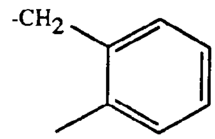
oder
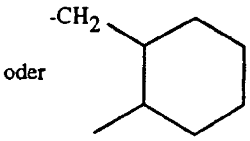
oder
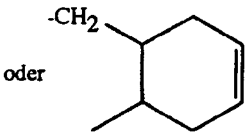

bedeuten, oder -Y-$R_{21}$ für $R_{20}$ mit Ausnahme von Wasserstoff steht
Y eine Gruppe -CO-, -CS-, -COO-, -$SO_2$- oder -Si($R_{23}$)$_2$- bedeutet, worin $R_{23}$ die zuvor gegebene Bedeutung hat,
$R_{22}$ eine der für $R_{21}$ gegebenen Bedeutungen hat oder
$R_{22}$ und $R_{21}$ zusammen $C_1$-$C_8$-Alkandiyl, $C_2$-$C_8$-Alkendiyl, $C_6$-$C_{14}$-Arendiyl, $C_4$-$C_{12}$-Cycloalkandiyl, $C_5$-$C_{12}$-Cycloalkendiyl, $C_6$-$C_{14}$-Cycloalkadiendiyl, $C_7$-$C_{20}$-Bicycloalkandiyl, $C_7$-$C_{20}$-Bicycloalkendiyl oder durch -O-, -S- oder -N($R_{26}$)- unterbrochenes $C_2$-$C_4$-Alkandiyl bedeuten, wobei diese Reste unsubstituiert oder durch einen oder mehrere der Substituenten Halogen, $C_1$-$C_{10}$-Alkoxy, $C_1$-$C_{20}$-Alkyl, $C_3$-$C_{20}$-Alkenyl oder $C_6$-$C_{14}$-Aryl substituiert sind, dadurch gekennzeichnet, dass man 1 Mol-Äquivalent einer Verbindung der Formel $(R_1)_2TiX_2$, worin $R_1$ die oben angegebene Bedeutung hat und X Cl, Br oder J bedeutet, und 2 Mol-Äquivalente eines Azomethins der Formel XII

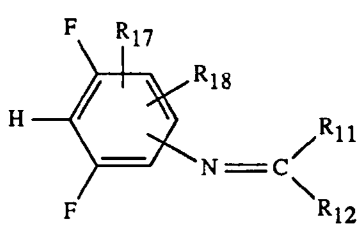
(XII),

worin
$R_{11}$ unsubstituiertes oder durch Halogen, $C_1$-$C_{12}$-Alkoxy oder $C_2$-$C_8$-Dialkylamino substituiertes $C_1$-$C_{12}$-Alkyl, unsubstituiertes oder durch $C_1$-$C_8$-Alkoxy, -$(OCH_2CH_2)_p$-O-$C_1$-$C_{12}$-Alkyl mit p = 1-20, $C_1$-$C_8$-Alkylthio, $C_2$-$C_8$-Dialkylamino, Halogen oder Nitro substituiertes $C_6$-$C_{14}$-Aryl, $C_7$-$C_{20}$-Aralkyl, $C_7$-$C_{20}$-Alkaryl oder $C_8$-$C_{20}$-Alkarylalkyl bedeutet,
$R_{12}$ Wasserstoff ist oder eine der für $R_{11}$ gegebenen Bedeutungen hat,
mit 2 bis 2,5 Mol-Äquivalenten eines Lithiumamides der Formel LiN($R_{15}$)($R_{16}$), worin $R_{15}$ und $R_{16}$ wie in Anspruch 1 definiert sind, bei -30°C bis 25°C in einem inerten Lösungsmittel zu einem Titanocen der Formel XIII

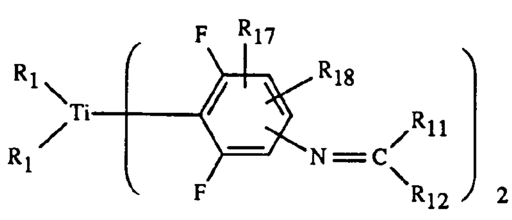
(XIII),

worin $R_{17}$, $R_{18}$, $R_{11}$ und $R_{12}$ die oben angegebene Bedeutung haben, umsetzt, letzteres hydrolisiert und gegebenenfalls das so erhaltene $NH_2$-Produkt der Formel

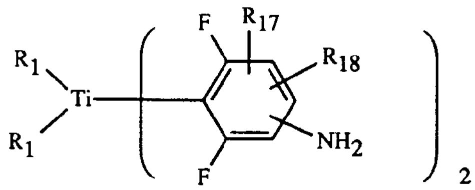

(XIV)

nach bekannten Alkylierungs- und Acylierungsmethoden in die Verbindung der Formel X überführt.

Die Titanocene der Formel X stellen wertvolle Photoinitiatoren dar. Sie und ihre Verwendung sind in der EP-A 0 318 839 näher beschrieben. Die Umsetzung von Verbindungen der Formel XIV zu Verbindungen der Formel X kann nach üblichen Alkylierungs- und Acylierungsmethoden erfolgen, wie sie z.B. auch in der EP-A 0 318 893 für die Vorprodukte der Formeln VI und VIIa (siehe z.B. Seite 9, Zeile 11 bis Seite 10, Zeile 8, skizziert sind. Siehe auch das nachfolgende Beispiel 11).

Verbindungen der Formel XIV können beispielsweise durch Umsetzung mit Verbindungen der Formeln $HalYR_{21}$, $HalYR_{22}$, $R_{21}$-N=C=O, $R_{22}$-N=C=O, $R_{21}$-N=C=S, $R_{22}$-N=C=S, $R_{20}Hal$,

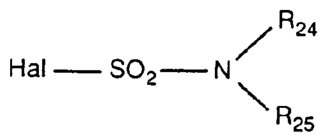

,

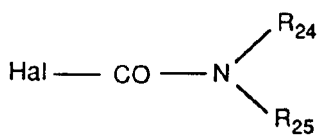

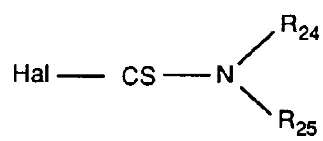

Hal-Y-$R_{21}$-$R_{22}$-Y-Hal, worin Hal für Halogen (Cl, Br oder J) steht, zu Verbindungen der Formel X umgesetzt werden.

Die folgenden Beispiele erläutern das neue Verfahren und die dadurch herstellbaren Produkte weiter. Darin sind alle Temperaturen in °C angegeben. Prozente und Teile beziehen sich darin sowie in der übrigen Beschreibung und in den Patentansprüchen auf das Gewicht, sofern nichts anderes angegeben ist.

Beispiel 1: Herstellung von Bis(cyclopentadienyl)-bis[2,6-difluor-3-(1-pyrryl)-phenyl]-titan

Methode A (Reaktion bei -10°C. Sauer-wässrige Aufarbeitung)

Zu einer Lösung von 3 ml (0,02 Mol) destilliertem Diisopropylamin in 20 ml trockenem Tetrahydrofuran (THF) werden unter Argon als Schutzgas bei 0°C 13,1 ml einer 1,6 molaren Lösung von Butyllithium in Hexan (0,02 Mol) unter Rühren zugetropft. Die enstandene Lösung wird zu einer Suspension von 2,5 g (0,01 Mol) Dicyclopentadienyltitandichlorid und 3,96 g (0,022 Mol) N-(2,4-Difluorphenyl)-pyrrol in 20 ml THF bei -10°C unter Argon als Schutzgas innerhalb von 30 Minuten unter Rühren zugetropft.

Nach weiteren 30 Minuten Rühren wird die Kühlung entfernt. Wenn die entstandene Suspension Raumtemperatur erreicht hat, wird eine Lösung von 2,5 g Oxalsäure in 10 ml THF zugegeben. Nach Zugabe von Wasser wird mit Ethylacetat extrahiert. Die organische Phase wird über $MgSO_4$ getrocknet und im Vakuum eingedampft. Das Rohprodukt wird in Ethylacetat/Petrolether 1:4 gelöst und an einer Kieselgel ($SiO_2$)-Säule chromatographisch gereinigt. Man erhält 4,7 g (87,8 % der Theorie) als orange Kristalle, die bei 160-163° schmelzen.

Methode B (Reaktion bei -10°C. Sauer-ethanolische Aufarbeitung)

Zu einer Lösung von 68 ml (0,48 Mol) Diisopropylamin in 145 ml absolutem Tetrahydrofuran (THF) wird unter $N_2$ bei 0°C 315 ml einer 1,52 molaren Lösung von Butyllithium in Hexan (0,48 Mol) zugetropft.
Diese Lösung wird zu einer Suspension von 56,9 g (0,228 Mol) Dicyclopentadienyltitandichlorid und 81,9 g (0,457 Mol) N-(2,4-Difluorphenyl)-pyrrol in 145 ml THF bei -10°C innerhalb 1½ h zugetropft. Anschliessend wird die Kühlung entfernt und bis zum Erreichen der Raumtemperatur gerührt. Dann wird die Reaktionsmischung im Vakuum auf die Hälfte eingeengt und auf ein Gemisch von 510 ml 75%-igem wässrigem Ethanol und 27,4 ml Essigsäure (0,48 Mol) gegossen. Hierbei fällt das Produkt kristallin aus. Man kühlt auf 0°C, filtriert das Produkt ab und wäscht es mit 50%-igem wässrigem Ethanol. Nach Trocknung im Vakuum bei 40°C erhält man 103 g (84,3 % der Theorie) orange Kristalle, die bei 156-160°C schmelzen.

Methode C (Reaktion bei -10°C. Wasserfreie Aufarbeitung)

Man arbeitet wie in Methode A oder B, die Aufarbeitung erfolgt aber so: Das Reaktionsgemisch wird im Vakuum zur Trockene eingedampft. Der Rückstand wird in Methylenchlorid aufgenommen, die Lösung wird vom LiCl abfiltriert und erneut eingedampft. Das Rohprodukt wird in Toluol gelöst und durch Zusatz von Ethanol zur Kristallisation gebracht. Man erhält das Reinprodukt vom Smp. 163-165°C in einer Ausbeute von 65,6 % der Theorie. Weitere 30 % werden durch Chromatographie der Mutterlauge erhalten.

Methode D (Reaktion bei Raumtemperatur. Sauer-wässrige Aufarbeitung)

Es wird wie bei Methode A oder B gearbeitet, jedoch erfolgt das Zutropfen der Lithiumdiisopropylamid-Lösung bei Raumtemperatur. Die Aufarbeitung geschieht durch Versetzen mit wässriger Essigsäure, Eindampfen der organischen Phase und Kristallisation aus Ethanol. Das Produkt wird in 80 % Ausbeute erhalten und schmilzt bei 160-162°C.

Beispiel 2: Herstellung von Verbindungen der Formel

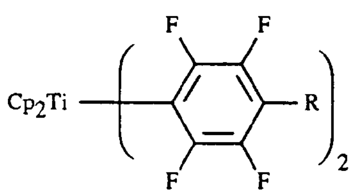

Cp = Cyclopentadienyl

In analoger Weise zu Beispiel 1, Methode A, werden die folgenden Verbindungen der obigen Formel hergestellt.

| R | Reaktionstemperatur | Ausbeute | Schmp. |
|---|---|---|---|
| H | -15°C | 65,3 % | 180-187°C |
| F | +23°C | 64,3 % | 216-220°C |
| $-OC_2H_5$ | -20°C | 75,2 % | 167-170°C |
| $-N(C_4H_9)_2$ | -18°C | 65,5 % | 92-98°C |
| $-OC_{10}H_{21}$ | -10°C | 47,1 % | flüssig* |

* Elementaranalyse: Berechnet: 63,96 % C, 6,65 % H; Gefunden: 63,29 % C, 6,76 % H

Beispiel 3: Herstellung von Verbindungen der Formel

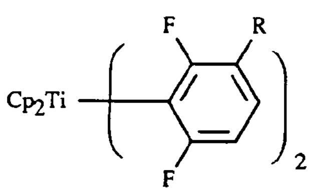

In analoger Weise zu Beispiel 1 werden die folgenden Verbindungen der obigen Formel hergestellt.

| R | Reaktions-temperatur | Ausbeute | Schmp. | Methode |
|---|---|---|---|---|
| H | 0°C | 88,5 % | 180-185°C | A |
| $-OC_4H_9$ | -18°C | 81,3 % | 90-95°C | A |
| $-N(CH_3)_2$ | -10°C | 66,4 % | 128-130°C | |
| 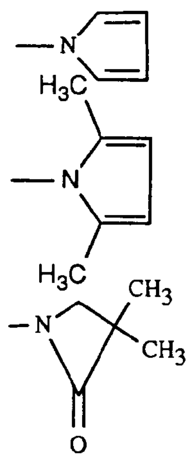 | -3°C | 87,8 % | 160-165°C | A |
| | -10°C | 44,0 % | 114-116°C | A |
| | -18°C | 61,5 % | 130-140°C | A |
| $-OSi(CH_3)_3$ | -10°C | 73,5 % | <20°C | C |
| 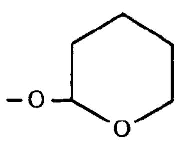 | -10°C | 54,5 % | 85-93°C | A |
| 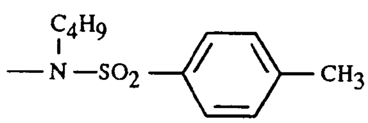 | -10°C | 48,9 % | 76-80°C | A |

Beispiel 4: Herstellung von Verbindungen der Formel

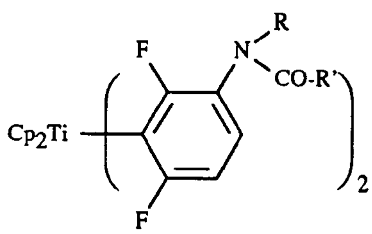

In analoger Weise zu Beispiel 1, Methode A, werden die folgenden Verbindungen der obigen Formel hergestellt.

| R | | Reaktions-temperatur | Ausbeute | Schmp. |
|---|---|---|---|---|
| n-Hexyl | $CH_3$<br>$-C-C_2H_5$<br>$CH_3$ | -18°C | 84,6 % | 98-103°C |
| 2-Ethylhexyl | Phenyl | -10°C | 71,8 % | 80-86°C |
| Cyclohexylmethyl | p-Tolyl | -10°C | 68,6 % | 130-140°C |
| n-Hexyl | Phenyl | -10°C | 69,2 % | 78-88°C |
| n-Butyl | Phenyl | -10°C | 70 % | 180-185°C |
| t-Butyl | $CH_3$<br>$-C-CH_2CH_2Cl$<br>$CH_3$ | -10°C | 70,5 % | 95-100°C |
| 2-Ethylhexyl | Phenyl | -30°C | 71,7 % | 80-86°C |
| Cyclohexylmethyl | $CH_3$<br>$-C-(CH_2)_4-CH_3$<br>$C_2H_5$ | -10°C | 71,2 % | 85-90°C |
| Cyclohexylmethyl | 4-Chlorphenyl | -10°C | 69,9 % | 133-135°C |
| n-Hexyl | $CH_3$<br>$-C-(CH_2)_4-CH_3$<br>$C_2H_5$ | -10°C | 74,7 % | 45-55°C |

Beispiel 5: Herstellung von Verbindungen der Formel

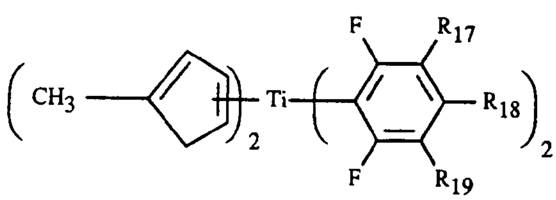

In analoger Weise zu Beispiel 1, Methode A, werden die folgenden Verbindungen der obigen Formel hergestellt.

| $R_{17}$ | $R_{18}$ | $R_{19}$ | Reaktions-temperatur | Ausbeute | Schmp. |
|---|---|---|---|---|---|
| H | H | H | -10°C | 54,1 % | 152-158°C |
| H | F | H | +10°C | 63,6 % | 155-165°C |
| F | F | F | -20°C | 52,2 % | 185-193°C |
| F | $-OC_2H_5$ | F | +10°C | 52 % | 155-160°C |
| F | $-N(C_4H_9)_2$ | F | -20°C | 80,2 % | Oel |
| $-OC_4H_9$ | H | H | 0°C | 88,2 % | 85-90°C |
| 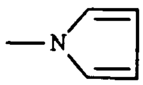 | H | H | 0°C | 76,4 % | 73-83°C |
| 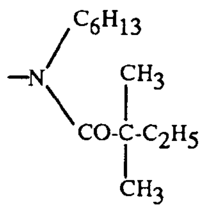 | H | H | -20°C | 75,2 % | 50-60°C |

Beispiel 6: Herstellung von Verbindungen der Formel

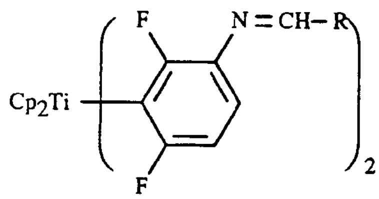

In analoger Weise zu Beispiel 1, Methode C, werden die Verbindungen der obigen Formel hergestellt.

| R | Reaktions-temperatur | Schmp. | | Analyse (%) C | H | N |
|---|---|---|---|---|---|---|
| Phenyl | -20°C | 135-145°C | ber. | 70,8 | 4,3 | 4,6 |
| | | | gef. | 70,8 | 4,7 | 4,2 |
| 4-Methoxyphenyl | -20°C | 117°C(Zers.) | ber. | 68,1 | 4,5 | 4,2 |
| | | | gef. | 68,6 | 4,2 | 3,6 |
| 4-Chlorphenyl | -20°C | 210-213°C | ber. | 63,6 | 3,6 | 4,1 |
| | | | gef. | 63,4 | 3,6 | 4,0 |
| 4-Methylphenyl | -20°C | 210-213°C | ber. | 71,5 | 4,7 | 4,4 |
| | | | gef. | 71,0 | 4,9 | 4,3 |
| 3-Nitrophenyl | -20°C | 120°C (Zers.) | ber. | 61,7 | 3,5 | 8,0 |
| | | | gef. | 61,7 | 3,5 | 7,8 |

Beispiel 7: Herstellung der Azomethinderivate

N-Benzal-2,4-difluoranilin

322,8 g (2,5 Mol) 2,4-Difluoranilin, 265,3 g (2,5 Mol) Benzaldehyd und 1000 ml Toluol werden auf Rückfluss erhitzt und das entstehende Wasser mit einem Wasserabscheider bei 90-105°C während 5 Stunden entfernt.

Das Toluol wird am Vakuumrotationsverdampfer abdestilliert und das Produkt aus Hexan umkristallisiert. Es werden 516,9 g (92,5 % der Theorie) N-Benzal-2,4-difluoranilin erhalten, das bei 51-52°C schmilzt.

N-(4-Methylbenzal)-2,4-difluoranilin

Analog wird aus p-Toluylaldehyd N-(4-Methylbenzal)-2,4-difluoranilin in einer Ausbeute von 81 % der Theorie erhalten. Die weissen Kristalle aus Hexan schmelzen bei 67°C.

| Elementaranalyse: $C_{14}H_{11}F_2N$ | | | |
|---|---|---|---|
| | C | H | N |
| Berechnet: | 72,72 % | 4,79 % | 6,06 % |
| Gefunden: | 72,72 % | 4,83 % | 5,88 % |

Beispiel 8: Hydrierung der Azomethinderivate

N-Benzyl-2,4-difluoranilin

In einem Autoklaven werden 195,4 g (0,9 Mol) N-Benzal-2,4-difluoranilin in 900 ml Tetrahydrofuran gelöst. Nach Zusatz von 19 g Raney-Nickel und 2 g Essigsäure wird bei 60 bis 85°C und 100 bar Wasserstoffdruck hydriert. Der Endpunkt der Reaktion wird dünnschicht- oder gaschromatographisch bestimmt. Die Suspension wird filtriert und am Vakuumrotationsverdampfer eingeengt. Der Rückstand wird im Vakuum bei 102°C und 3,6 mbar destilliert. Man erhält 125,6 g (64 % der Theorie) einer hellgelben Flüssigkeit.

| Elementaranalyse: $C_{13}H_{11}F_2N$ | | | |
|---|---|---|---|
| | C | H | N |
| Berechnet: | 71,22 % | 5,06 % | 6,39 % |
| Gefunden: | 71,07 % | 5,16 % | 6,38 % |

N-(2,4-Difluorphenyl)-4-methylbenzylamin wird analog hergestellt. Der Rückstand wird aus Hexan umkristallisiert. Man erhält 121,1 g (65 % der Theorie) weisse Kristalle, die bei 42-44°C schmelzen.

| Elementaranalyse: $C_{14}H_{13}F_2N$ | | | |
|---|---|---|---|
| | C | H | N |
| Berechnet: | 72,09 % | 5,62 % | 6,00 % |
| Gefunden: | 71,44 % | 5,63 % | 6,20 % |

Beispiel 9: Herstellung der 2,4-Difluoranilide

N-Benzyl-N-(2,2-dimethylpentanoyl)-2,4-difluoranilin

In einem Rundkolben werden 17,5 g (80 mMol) N-Benzyl-2,4-difluoranilin und 16,2 g (160 mMol) Triethylamin in 100 ml Ether gelöst. Zu dieser Lösung werden bei Raumtemperatur langsam 11,9 g (80 mMol) 2,2-Dimethylpentansäurechlorid in 30 ml Ether zugetropft. Anschliessend wird über Nacht nachgerührt. Es fällt langsam Triethylammoniumchlorid aus. Nach beendeter Reaktion wird die Suspension mit 250 ml Ether verdünnt und auf 250 ml Wasser gegossen. Mit 5%iger Salzsäurelösung wird angesäuert. Die beiden Phasen werden getrennt und die organische Phase wird zweimal mit Wasser nachgewaschen, mit $MgSO_4$ getrocknet und am Vakuumrotationsverdampfer eingeengt. Der Rückstand, ein farbloses Oel, erstarrt beim Stehenlassen. Er schmilzt bei 55-60°C.

Elementaranalyse: $C_{20}H_{23}F_2NO$

| | C | H | N |
|---|---|---|---|
| Berechnet: | 72,49 % | 7,00 % | 4,23 % |
| Gefunden: | 72,39 % | 6,95 % | 4,22 % |

N-(4-Methylbenzyl)-N-(2,2-dimethylpentanoyl)-2,4-difluoranilin wird analog aus N-(2,4-Difluorphenyl)-4-methylbenzylamin hergestellt. Die weissen Kristalle schmelzen bei 76-77°C.

Elementaranalyse: $C_{21}H_{25}F_2NO$

| | C | H | N |
|---|---|---|---|
| Berechnet: | 73,02 % | 7,29 % | 4,05 % |
| Gefunden: | 73,07 % | 7,53 % | 4,01 % |

Beispiel 10: Herstellung der Titanocene

a) Bis(cyclopentadienyl)-bis[2,6-difluor-3-(N-benzyl-2,2-dimethylpentanoylamino)phenyl]-titan

In analoger Weise zu Beispiel 1, Methode A, wird aus N-Benzyl-N-(2,2-dimethylpentanoyl)-2,4-difluoranilin das entsprechende Titanocen bei -10°C hergestellt. Nach der chromatographischen Reinigung über eine Kieselgelsäule erhält man ein glasartiges oranges Produkt.

Elementaranalyse: $C_{50}H_{54}F_4N_2O_2Ti$

| | C | H | N |
|---|---|---|---|
| Berechnet: | 71,59 % | 6,49 % | 3,34 % |
| Gefunden: | 71,40 % | 6,62 % | 2,87 % |

b) Bis(cyclopentadienyl)-bis[2,6-difluor-3-(N-(4-methylbenzyl)-2,2-dimethylpentanoylamino)phenyl]-titan wird analog aus N-(4-Methylbenzyl)-N-(2,2-dimethylpentanoyl)-2,4-difluoranilin hergestellt.
Nach der Reinigung erhält man ein glasartiges oranges Produkt.

Elementaranalyse: $C_{52}H_{58}F_4N_2O_2Ti$

| | C | H | N |
|---|---|---|---|
| Berechnet: | 72,04 % | 6,74 % | 3,23 % |
| Gefunden: | 71,08 % | 7,02 % | 2,79 % |

Beispiel 11: Herstellung von Bis(cyclopentadienyl)-bis(2,6-difluor-3-aminophenyl)-titan ohne Isolierung der Azomethinzwischenstufe Bis(cyclopentadienyl)-bis[2,6-difluor-3-(N-benzal-amino)phenyl]-titan

Analog Beispiel 1, Methode A, werden bei -10°C 477,9 g (2,2 Mol) N-Benzal-2,4-difluoranilin mit 248,8 g (1,0 Mol) Titanocendichlorid zum Bis(cyclopentadienyl)-bis[2,6-difluor-3-(N-benzal-amino)phenyl]-titan umgesetzt. Wenn die entstandene gelbbraune Suspension Raumtemperatur erreicht hat, wird sie am Vakuumrotationsverdampfer eingeengt. Der Rückstand wird in 3000 ml Methylenchlorid aufgenommen und über Hyflo geklärt. Das Filtrat wird erneut eingeengt. Der Rückstand wird in 2000 ml Ethylacetat gelöst und mit 2000 ml 2N Salzsäurelösung versetzt. Nach drei Stunden Rühren zur Hydrolyse werden die Phasen getrennt. Die organische Phase wird dreimal mit je 200 ml 2N Salzsäurelösung extrahiert. Die wässrigen Phasen werden vereinigt und einmal mit 500 ml Ethylacetat gewaschen. Die Wasserphase wird mit 500 ml Ethanol versetzt und

dann unter Kühlung bei 10-15°C mit 30%iger Natronlauge neutralisiert. Dann wird auf 5°C gekühlt. Die entstandene rotbraune Suspension wird filtriert und bei 40°C im Vakuum getrocknet. Es werden 391,8 g (90,2 % der Theorie) orangerote Kristalle erhalten, die über 250°C unter Zersetzung schmelzen.

| Elementaranalyse: $C_{22}H_{18}F_4N_2Ti$ | | | |
|---|---|---|---|
| | C | H | N |
| Berechnet: | 60,84 % | 4,18 % | 6,45 % |
| Gefunden: | 60,93 % | 4,37 % | 6,19 % |

Beispiel 12: Photohärtung eines Acrylat-Gemisches

Es wird eine photohärtbare Zusammensetzung hergestellt durch Mischen der folgenden Komponenten:

| | | Feststoffgehalt |
|---|---|---|
| 150,30 g | Scriptset 540[1] (30 %-ige Lsg. in Aceton) | 45,1 g |
| 48,30 g | Trimethylolpropantriacrylat | 48,3 g |
| 6,60 g | Polyethylenglykoldiacrylat | 6,6 g |
| 0,08 g | Kristallviolett | |
| 205,28 g | | 100,0 g |

[1] Polystyrol-Maleinsäureanhydrid-Copolymer (Monsanto)

Portionen dieser Zusammensetzung werden mit jeweils 0,3 % (bezogen auf den Feststoffgehalt) an Photoinitiator vermischt. Alle Operationen werden unter Rotlicht ausgeführt.

Die mit Initiator versetzten Proben werden in einer Stärke von 150 µm auf 200 µm Aluminiumfolie (10 x 15 cm) aufgetragen. Das Lösungsmittel wird durch Erwärmung auf 60°C während 15 Minuten im Umluftofen entfernt. Auf die flüssige Schicht wird eine 76 µm dicke Polyesterfolie gelegt und auf diese ein standardisiertes Testnegativ mit 21 Stufen verschiedener optischer Dichte (Stouffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 10 Sekunden, einer zweiten Testreihe 20 Sekunden und einer dritten Testreihe 40 Sekunden. Nach der Belichtung werden die Folien und die Maske entfernt, die belichtete Schicht in einem Ultraschallbad 120 Sekunden mit Entwickler A entwickelt und anschliessend bei 60° C 15 Minuten im Umluftofen getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 1 angegeben. Entwickler A enthält 15 g Natriummetasilikat · 9 $H_2O$; 0,16 g KOH; 3 g Polyethylenglykol 6000; 0,5 g Lävulinsäure und 1000 g deionisiertes Wasser.

Tabelle 1:

| Titanocen Beispiel | Zahl der abgebildeten Stufen nach 10s | 20s | 40s Belichtung |
|---|---|---|---|
| 10a | 9 | 12 | 14 |
| 10b | 8 | 10 | 12 |

Beispiel 13: Photohärtung eines Monomer-Polymer-Gemisches

Es wird eine photohärtbare Zusammensetzung hergestellt durch Mischen der folgenden Komponenten:

| | |
|---|---|
| 37,64 g | Sartomer SR 444 (Pentaerythritol-triacrylat) (Sartomer Company, Westchester) |
| 10,76 g | Cymel 301 Hexamethoxymethylmelamin (Cyanamid) |
| 47,30 g | Carboset 525 (Thermoplastisches Polyacrylat mit Carboxylgruppen/ B.F. Goodrich) |
| 4,30 g | Polyvinylpyrrolidon PVP (GAF) |
| 100,00 g | der obigen Mischung |
| 0,50 g | Irgalitgrün GLN |
| 319,00 g | Methylenchlorid |
| 30,00 g | Methanol |
| 450,00 g | |

Portionen dieser Zusammensetzung werden mit jeweils 0,3 % (bezogen auf den Feststoff) der in der folgenden Tabelle angegebenen Titanocene vermischt. Alle Operationen werden unter Rotlicht ausgeführt.

Die mit Initiator versetzten Proben werden in einer Stärke von 200 μm auf 200 μm Aluminiumfolie (10 x 15 cm) aufgetragen. Das Lösungsmittel wird durch Erwärmung auf 60°C während 15 Minuten im Umluftofen entfernt. Auf die flüssige Schicht wird eine 76 μm dicke Polyesterfolie gelegt und auf diese ein standardisiertes Testnegativ mit 21 Stufen verschiedener optischer Dichte (Stouffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 10 Sekunden, in einer zweiten Testreihe 20 Sekunden und in einer dritten Testreihe 40 Sekunden. Nach der Belichtung werden die Folien und die Maske entfernt, die belichtete Schicht in einem Ultraschallbad 240 Sekunden mit Entwickler A entwickelt und anschliessend bei 60°C 15 Minuten im Umluftofen getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 2 angegeben.

Tabelle 2:

| Titanocen Beispiel | Zahl der abgebildeten Stufen nach 10s | 20s | 40s Belichtung |
|---|---|---|---|
| 10a | 9 | 12 | 15 |
| 10b | 7 | 10 | 13 |

**Patentansprüche**

1. Verfahren zur Herstellung von Titanocenen der Formel I,

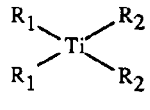

I

worin $R_1$ unsubstituiertes oder ein- oder mehrfach durch $C_1$-$C_{18}$-Alkyl, $C_1$-$C_{18}$-Alkoxy, $C_2$-$C_{18}$-Alkenyl, $C_5$-$C_8$-Cycloalkyl, $C_6$-$C_{10}$-Aryl, $C_7$-$C_{16}$-Aralkyl, -Si$(R_3)_4$, -Ge$(R_3)_4$ oder Halogen substituiertes Cyclopentadienyl$^{\ominus}$, Indenyl$^{\ominus}$ oder 4,5,6,7-Tetrahydroindenyl$^{\ominus}$ bedeutet oder beide $R_1$ zusammen einen zweiwertigen Rest der Formel II bedeuten,

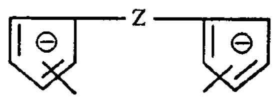

II

worin Z-$(CH_2)_m$- mit m = 1, 2 oder 3, gegebenenfalls mit Phenyl substituiertes $C_2$-$C_{12}$-Alkyliden, -Si$(R_3)_2$- oder -Si$(R_3)_2$-O-Si$(R_3)_2$- bedeutet und

$R_3$ $C_1$-$C_{12}$-Alkyl oder $C_6$-$C_{10}$-Aryl bedeutet,

$R_2$ einen Phenylring bedeutet, der in beiden Orthopositionen zur Ti-C-Bindung mit Fluor substituiert ist und der ausserdem durch weitere Fluoratome, durch $C_1$-$C_4$-Alkyl oder durch eine der Gruppen III bis VII substituiert sein kann,

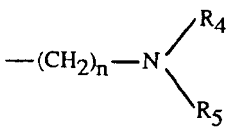 III, 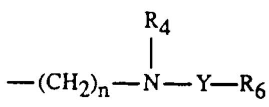 IV, 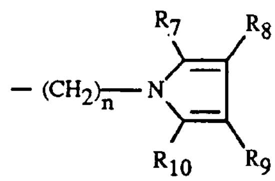 V,

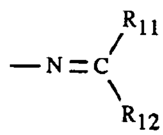 VI,

-O-$R_{13}$ VII

worin n eine ganze Zahl von 0 bis 6 bedeutet,

$R_4$ $C_1$-$C_{20}$-Alkyl, $C_3$-$C_{10}$-Cycloalkyl, $C_4$-$C_{20}$-Cycloalkylalkyl, $C_4$-$C_{20}$-Alkylcycloalkyl, $C_5$-$C_{20}$-Alkylcycloalkylalkyl, $C_6$-$C_{14}$-Aryl, $C_7$-$C_{20}$-Aralkyl, $C_7$-$C_{20}$-Alkaryl, $C_8$-$C_{20}$-Alkaralkyl, $C_3$-$C_{12}$-Alkoxyalkyl, Tetrahydrofurfuryl oder einen Rest -$(CH_2CH_2O)_p$-$C_1$-$C_{12}$-Alkyl mit p = 1-20 bedeutet, $R_5$ eine der für $R_4$ gegebenen Bedeutungen hat oder $R_4$ und $R_5$ zusammen $C_3$-$C_8$-Alkylen bedeuten, das durch -O-, -S- oder -N$(R_{14})$- unterbrochen sein kann, oder $R_4$ und $R_5$ zusammen -Si$(R_3)_2$-$CH_2CH_2$-Si$(R_3)_2$- bedeuten,

Y -CO-, -CS-, -COO-, -CON$(R_{14})$-, -$SO_2$-, -$SO_2$N$(R_{14})$- oder -Si$(R_3)_2$- bedeutet,

$R_6$ $C_4$-$C_{20}$-Alkyl, $C_2$-$C_{20}$-Alkaryl, $C_4$-$C_{10}$-Cycloalkyl, $C_5$-$C_{20}$-Cycloalkylalkyl, $C_5$-$C_{20}$-Alkylcycloalkyl, $C_6$-$C_{20}$-Alkylcycloalkylalkyl, $C_6$-$C_{14}$-Aryl, $C_7$-$C_{20}$-Aralkyl, $C_7$-$C_{20}$-Alkaryl oder $C_8$-$C_{20}$-Alkarylalkyl bedeutet, wobei diese Reste unsubstituiert oder durch $C_1$-$C_{18}$-Alkoxy, $C_1$-$C_{18}$-Alkylthio oder Halogen substituiert sein können,

oder $R_5$ und $R_4$ zusammen $C_4$-$C_8$-Alkylen bedeuten, das durch -O-, -S- oder -N$(R_{14})$-unterbrochen sein kann,

mit der Bedingung, dass das zu Y benachbarte C-Atom von $R_5$ kein H-Atom trägt, wenn Y -CO-, -CS- oder -$SO_2$- ist,

$R_7$, $R_8$, $R_9$ und $R_{10}$ unabhängig voneinander Wasserstoff, unsubstituiertes oder durch $C_2$-$C_8$-Dialkylamino, Bis[2-($C_1$-$C_4$-alkoxy)-ethyl]amino, Morpholino, Piperidino, $C_2$-$C_{12}$-Alkoxy, -$(OCH_2CH_2)_p$-O-$C_1$-$C_{12}$-Alkyl mit p = 1-20, 1,3-Dioxolan-2-yl, $C_1$-$C_{12}$-Alkylthio oder Halogen substituiertes $C_1$-$C_{18}$-Alkyl, $C_2$-$C_5$-Alkenyl, $C_7$-$C_9$-Phenylalkyl oder $C_7$-$C_{12}$-Alkylphenyl bedeuten, oder 2-Furyl oder -Si$(R_3)_3$ bedeuten,

$R_{11}$ unsubstituiertes oder durch Halogen, $C_1$-$C_{12}$-Alkoxy oder $C_2$-$C_8$-Dialkylamino substituiertes $C_1$-$C_{12}$-Alkyl, unsubstituiertes oder durch $C_1$-$C_8$-Alkoxy, -$(OCH_2CH_2)_p$-O-$C_1$-$C_{12}$-Alkyl mit p = 1-20, $C_1$-$C_8$-Alkylthio, $C_2$-$C_8$-Dialkylamino, Halogen oder Nitro substituiertes $C_6$-$C_{14}$-Aryl, $C_7$-$C_{20}$-Aralkyl, $C_7$-$C_{20}$-Alkaryl oder $C_8$-$C_{20}$-Alkarylalkyl bedeutet,

$R_{12}$ Wasserstoff ist oder eine der für $R_{11}$ gegebenen Bedeutungen hat,

$R_{13}$ $C_1$-$C_{18}$-Alkyl, $C_3$-$C_{12}$-Cycloalkyl, $C_2$-$C_5$-Alkenyl, Glycidyl, -$(CH_2CH_2O)_p$-$C_1$-$C_{12}$-Alkyl mit p = 1-20, $C_6$-$C_{10}$-Aryl, $C_7$-$C_{20}$-Aralkyl, $C_7$-$C_{20}$-Alkaryl oder

$C_8$-$C_{20}$-Alkarylalkyl bedeutet, wobei die Arylreste durch $C_1$-$C_4$-Alkoxy, $C_1$-$C_4$-Alkylthio, $C_2$-$C_8$-Dialkylami-

no, Halogen oder Nitro substituiert sein können, oder $R_{13}$ $C_1$-$C_{20}$-Halogenalkyl, -Si$(R_3)_3$, -Sn$(R_3)_3$ oder 2-Tetrahydropyranyl bedeutet und $R_{14}$ $C_1$-$C_{12}$-Alkyl, $C_3$-$C_5$-Alkaryl oder $C_7$-$C_9$-Phenylalkyl bedeutet, durch Umsetzung einer Verbindung der Formel VIII,

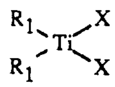

VIII

worin X Cl, Br oder J bedeutet, mit $LiR_2$, dadurch gekennzeichnet, dass man ein Gemisch von 1 Mol-Aequivalent der Verbindung der Formel VIII und 2 Mol-Aequivalenten einer Verbindung $HR_2$ mit 2 bis 2,5 Mol-Aequivalenten eines Lithiumamides bei -30°C bis +25°C in einem inerten Lösungsmittel umsetzt und nach Abtrennen des gebildeten LiX das Titanocen in üblicher Weise isoliert,
wobei das Lithiumamid eine Verbindung der Formel $LiN(R_{15})(R_{16})$ ist, worin $R_{15}$ und $R_{16}$ unabhängig voneinander in 1-Stellung verzweigtes Alkyl, Cyclohexyl oder Phenyl bedeuten oder $R_{15}$ und $R_{16}$ zusammen mit dem N-Atom ein 2,5-dialkyliertes Pyrrolidin oder ein 2,6-dialkyliertes oder 2,2,6,6-tetraalkyliertes Piperidin bedeutet.

2. Verfahren gemäss Anspruch 1, dadurch gekennzeichnet, dass man pro Mol-Aequivalent der Verbindung der Formel VIII 2,0 bis 2,2 Mol-Aequivalente des Lithiumamides verwendet.

3. Verfahren gemäss Anspruch 1, dadurch gekennzeichnet, dass man die Reaktion in Gegenwart eines polaren Lösungsmittels oder gegebenenfalls in einem Gemisch von polaren und unpolaren Lösungsmitteln ausführt.

4. Verfahren gemäss Anspruch 1, dadurch gekennzeichnet, dass man eine Verbindung der Formel VIII verwendet, worin X Chlor ist.

5. Verfahren gemäss Anspruch 1, dadurch gekennzeichnet, dass man als Lithiumamid Lithium-diisopropylamid, Lithium-cyclohexyl-isopropylamid, Lithium-dicyclohexylamid oder Lithium-2,2,6,6-tetramethylpiperidid, insbesondere Lithium-diisopropylamid, verwendet.

6. Verfahren gemäss Anspruch 1, dadurch gekennzeichnet, dass $R_1$ Cyclopentadienyl$^{\ominus}$ oder durch $C_1$-$C_4$-Alkyl substituiertes Cyclopentadienyl$^{\ominus}$, insbesondere Methylcyclopentadienyl$^{\ominus}$, bedeutet.

7. Verfahren gemäss Anspruch 1, dadurch gekennzeichnet, dass $R_2$ ein einwertiger Rest der Formel IX ist,

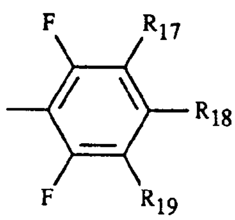

IX

worin $R_{17}$, $R_{18}$ und $R_{19}$ unabhängig voneinander Wasserstoff, Fluor, $C_1$-$C_4$-Alkyl oder eine Gruppe der Formel III-VII bedeuten.

8. Verfahren gemäss Anspruch 7, dadurch gekennzeichnet, dass in Formel IX $R_{17}$ oder $R_{18}$ eine Gruppe der Formel III-VII ist und die anderen Reste $R_{17}$, $R_{18}$ und $R_{19}$ Wasserstoff oder Fluor bedeuten.

9. Verfahren gemäss Anspruch 8, dadurch gekennzeichnet, dass $R_{17}$ oder $R_{18}$ eine Gruppe der Formel III-VII ist, worin n 0 oder 1 ist,
$R_4$ $C_1$-$C_{12}$-Alkyl, $C_3$-$C_{12}$-Alkoxy, Phenyl, $C_7$-$C_9$-Phenylalkyl, Cycloalkyl, Cyclohexylmethyl oder eine Gruppe -$(CH_2CH_2O)_p$-$C_1$-$C_4$-Alkyl mit p = 1-5 bedeutet,
$R_5$ eine der für $R_4$ gegebenen Bedeutungen hat oder $R_4$ und $R_5$ zusammen $C_4$-$C_5$-Alkylen bedeuten, das durch -O- oder -N$(R_{14})$- unterbrochen sein kann, wobei $R_{14}$ $C_1$-$C_4$-Alkyl bedeutet,
Y -CO-, -$SO_2$- oder -COO- bedeutet,

$R_6$ $C_4$-$C_{12}$-Alkyl, Phenyl oder durch $CH_3$, $CH_3O$ oder Cl substituiertes Phenyl oder $C_1$-$C_8$-Halogenalkyl bedeutet oder $R_6$ und $R_4$ zusammen $C_4$-$C_8$-Alkylen bedeuten, mit der Bedingung, dass das zu Y benachbarte C-Atom von $R_6$ kein H-Atom trägt,
$R_7$, $R_6$, $R_9$ und $R_{10}$ unabhängig voneinander Wasserstoff, $C_1$-$C_8$-Alkyl, $C_2$-$C_{12}$Alkoxyalkyl , $C_2$-$C_4$-Alkenyl, Phenyl oder 2-Furyl bedeuten,
$R_{11}$ unsubstituiertes oder durch $C_1$-$C_{12}$-Alkyl, $C_1$-$C_4$-Alkoxy, $C_1$-$C_4$-Alkylthio, Halogen oder Nitro substituiertes Phenyl bedeutet, $R_{12}$ Wasserstoff ist und
$R_{12}$ $C_1$-$C_{14}$-Alkyl, -$(CH_2CH_2O)_p$-$C_1$-$C_{12}$-Alkyl mit p = 1-20, Phenyl, Benzyl, 2-Tetrahydropyranyl oder -$Si(CH_3)_3$ bedeutet.

**10.** Verfahren zur Herstellung von Titanocenen der Formel X

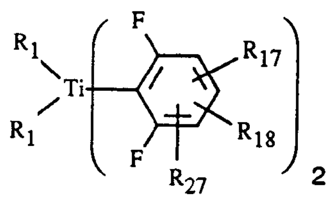

(X),

worin $R_1$ unsubstituiertes oder ein- oder mehrfach durch $C_1$-$C_{18}$-Alkyl, $C_1$-$C_{18}$-Alkoxy, $C_2$-$C_{18}$-Alkenyl, $C_5$-$C_8$-Cycloalkyl, $C_6$-$C_{10}$-Aryl, $C_7$-$C_{16}$-Aralkyl, -$Si(R_3)_4$, -$Ge(R_3)_4$ oder Halogen substituiertes Cyclopentadienyl$^{\ominus}$, Indenyl$^{\ominus}$ oder 4,5,6,7-Tetrahydroindenyl$^{\ominus}$ bedeutet oder beide $R_1$ zusammen einen zweiwertigen Rest der Formel II bedeuten,

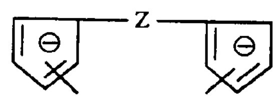

II

worin Z-$(CH_2)_m$- mit m = 1, 2 oder 3, gegebenenfalls mit Phenyl substituiertes $C_2$-$C_{12}$-Alkyliden, -$Si(R_3)_2$- oder -$Si(R_3)_2$-O-$Si(R_3)_2$- bedeutet und
$R_3$ $C_1$-$C_{12}$-Alkyl oder $C_6$-$C_{10}$-Aryl bedeutet,
$R_{17}$ und $R_{18}$ unabhängig voneinander Wasserstoff, Fluor oder $C_1$-$C_4$-Alkyl, und $R_{27}$-$NH_2$ oder eine Gruppe der Formel XI oder XIa bedeuten

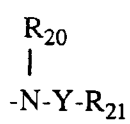

(XI)

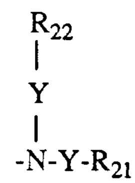

(XIa)

worin $R_{20}$ Wasserstoff, lineares oder verzweigtes $C_1$-$C_{20}$-Alkyl, $C_2$-$C_{20}$-Alkenyl, $C_3$-$C_8$-Cycloalkyl, $C_4$-$C_{20}$-Cycloalkylalkyl oder -Alkylcycloalkyl, $C_5$-$C_{20}$-Alkylcycloalkylalkyl, $C_6$-$C_{20}$-Cycloalkenylalkyl, $C_6$-$C_{14}$-Aryl, $C_7$-$C_{20}$-Aralkyl oder -Alkaryl, $C_8$-$C_{20}$-Alkaralkyl oder $C_3$-$C_{12}$-Trialkylsilyl darstellt, wobei diese Reste unsubstituiert oder durch $C_1$-$C_{18}$-Alkoxy, $C_1$-$C_{18}$-Alkylthio, $C_1$-$C_{18}$-Alkylsulfonyl, $C_6$-$C_{10}$-Arylsulfonyl, $C_7$-$C_{20}$-Alkarylsulfonyl, 2-Tetrahydrofuranyl oder Cyano substituiert sind,
$R_{21}$ eine der für $R_{20}$ gegebenen Bedeutungen hat oder $C_1$-$C_{20}$-Halogenalkyl, durch -CO-unterbrochenes $C_2$-$C_{20}$-Alkyl oder durch -COOH oder -$COOR_{23}$ substituiertes $C_1$-$C_{12}$-Alkyl ist, worin $R_{23}$ $C_1$-$C_{12}$-Alkyl, $C_5$-$C_{12}$-Cycloalkyl, $C_6$-$C_{16}$-Aryl oder $C_7$-$C_{16}$-Aralkyl ist, und im Falle, dass Y -CO-, -CS- oder -$SO_2$- ist, auch -$NR_{24}R_{25}$ bedeuten kann, worin $R_{24}$ und $R_{25}$ unabhängig voneinander eine der für $R_{20}$ gegebenen Bedeutungen haben oder $R_{24}$ und $R_{25}$ zusammen $C_3$-$C_7$-Alkylen bedeuten, das durch -O-, -S- oder -$N(R_{26})$- unterbrochen werden kann, worin $R_{26}$ Wasserstoff, $C_1$-$C_{12}$-Alkyl, $C_3$-$C_{12}$-Alkenyl, $C_7$-$C_{12}$-Aralkyl oder $C_2$-$C_{20}$-Alkanoyl bedeutet, oder $R_{20}$ und $R_{21}$ zusammen lineares oder verzweigtes $C_2$-$C_8$-Alkylen oder durch Ha-

logen, $C_1$-$C_4$-Alkoxy, Allyloxy oder -$NR_{24}R_{25}$ substituiertes $C_2$-$C_8$-Alkylen oder einen zweiwertigen Rest der Formel

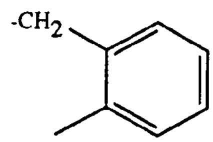

oder

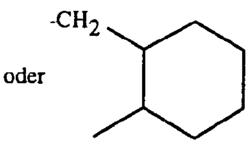

oder

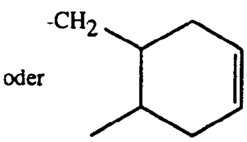

bedeuten, oder -Y-$R_{21}$ für $R_{20}$ mit Ausnahme von Wasserstoff steht

Y eine Gruppe -CO-, -CS-, -COO-, -$SO_2$- oder -$Si(R_{23})_2$- bedeutet, worin $R_{23}$ die zuvor gegebene Bedeutung hat,

$R_{22}$ eine der für $R_{21}$ gegebenen Bedeutungen hat oder

$R_{22}$ und $R_{21}$ zusammen $C_1$-$C_8$-Alkandiyl, $C_2$-$C_8$-Alkendiyl, $C_6$-$C_{14}$-Arendiyl, $C_4$-$C_{12}$-Cycloalkandiyl, $C_5$-$C_{12}$-Cycloalkendiyl, $C_6$-$C_{14}$-Cycloalkadiendiyl, $C_7$-$C_{20}$-Bicycloalkandiyl, $C_7$-$C_{20}$-Bicycloalkendiyl oder durch -O-, -S- oder -$N(R_{26})$- unterbrochenes $C_2$-$C_4$-Alkandiyl bedeuten, wobei diese Reste unsubstituiert oder durch einen oder mehrere der Substituenten Halogen, $C_1$-$C_{10}$-Alkoxy, $C_1$-$C_{20}$-Alkyl, $C_3$-$C_{20}$-Alkenyl oder $C_6$-$C_{14}$-Aryl substituiert sind, dadurch gekennzeichnet, dass man 1 Mol-Äquivalent einer Verbindung der Formel $(R_1)_2TiX_2$, worin $R_1$ die oben angegebene Bedeutung hat und X Cl, Br oder J bedeutet, und 2 Mol-Äquivalente eines Azomethins der Formel XII

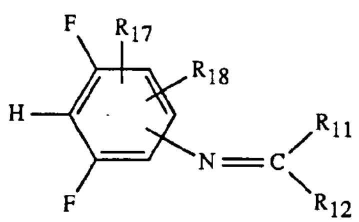

(XII),

worin

$R_{11}$ unsubstituiertes oder durch Halogen, $C_1$-$C_{12}$-Alkoxy oder $C_2$-$C_8$-Dialkylamino substituiertes $C_1$-$C_{12}$-Alkyl, unsubstituiertes oder durch $C_1$-$C_8$-Alkoxy, -$(OCH_2CH_2)_p$-O-$C_1$-$C_{12}$-Alkyl mit p = 1-20, $C_1$-$C_8$-Alkylthio, $C_2$-$C_8$-Dialkylamino, Halogen oder Nitro substituiertes $C_6$-$C_{14}$-Aryl, $C_7$-$C_{20}$-Aralkyl, $C_7$-$C_{20}$-Alkaryl oder $C_8$-$C_{20}$-Alkarylalkyl bedeutet,

$R_{12}$ Wasserstoff ist oder eine der für $R_{11}$ gegebenen Bedeutungen hat,

mit 2 bis 2,5 Mol-Äquivalenten eines Lithiumamides der Formel $LiN(R_{15})(R_{16})$, worin $R_{15}$ und $R_{16}$ wie in Anspruch 1 definiert sind, bei -30°C bis 25°C in einem inerten Lösungsmittel zu einem Titanocen der Formel XIII

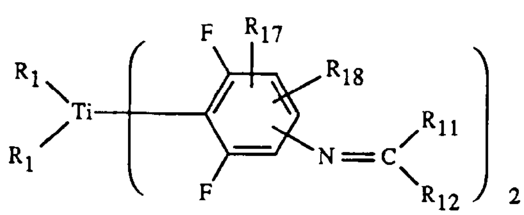

(XIII),

worin $R_{17}$, $R_{18}$, $R_{11}$ und $R_{12}$ die oben angegebene Bedeutung haben, umsetzt,

letzteres hydrolisiert und gegebenenfalls das so erhaltene $NH_2$-Produkt der Formel

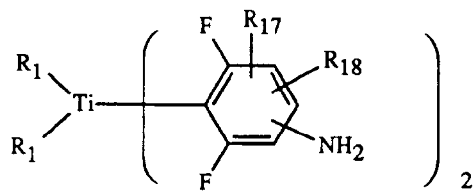 (XIV)

nach bekannten Alkylierungs- und Acylierungsmethoden in die Verbindung der Formel X überführt.

## Claims

1. A process for the preparation of a titanocene of the formula I

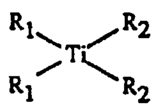 I

in which $R_1$ is cyclopentadienyl$^{\ominus}$, indenyl$^{\ominus}$ or 4,5,6,7-tetrahydroindenyl$^{\ominus}$, each of which is unsubstituted or monosubstituted or polysubstituted by $C_1$-$C_{18}$alkyl, $C_1$-$C_{18}$alkoxy, $C_2$-$C_{18}$alkenyl, $C_5$-$C_8$cycloalkyl, $C_6$-$C_{10}$aryl, $C_7$-$C_{16}$aralkyl, -$Si(R_3)_3$, -$Ge(R_3)_3$ or halogen, or both $R_1$ radicals together are a divalent radical of the formula II

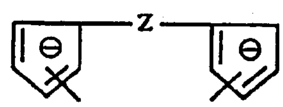 II

in which Z is -$(CH_2)_m$- where m - 1, 2 or 3, unsubstituted or phenyl-substituted $C_2$-$C_{12}$alkylidene, -$Si(R_3)_2$- or -$Si(R_3)_2$-O-$Si(R_3)_2$-, and $R_3$ is $C_1$-$C_{12}$alkyl or $C_6$-$C_{10}$aryl, $R_2$ is a phenyl ring which is substituted by fluorine in both the ortho positions to the Ti-C bond and which, in addition, may be substituted by further fluorine atoms, by $C_1$-$C_4$alkyl or by one of the groups III to VII,

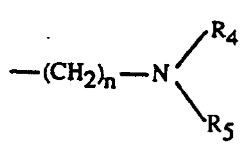 III, 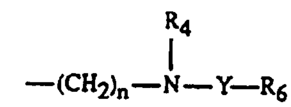 IV, 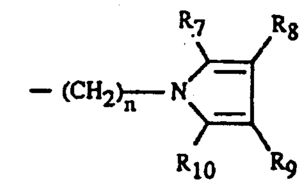 V,

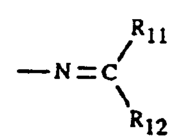 VI,

-O-$R_{13}$ VII

in which n is an integer from 0 to 6, $R_4$ is $C_1$-$C_{20}$alkyl, $C_3$-$C_{10}$cycloalkyl, $C_4$-$C_{20}$cycloalkylalkyl, $C_4$-$C_{20}$alkylcycloalkyl, $C_5$-$C_{20}$alkylcycloalkylalkyl, $C_6$-$C_{14}$aryl, $C_7$-$C_{20}$aralkyl, $C_7$-$C_{20}$alkaryl, $C_8$-$C_{20}$alkaralkyl, $C_3$-$C_{12}$alkoxyalkyl, tetrahydrofurfuryl or a -$(CH_2CH_2O)_p$-$C_1$-$C_{12}$alkyl radical where p = 1-20, $R_5$ has one of the meanings given for $R_4$, or $R_4$ and $R_5$ together are $C_3$-$C_8$alkylene, which may be interrupted by -O-, -S- or -$N(R_{14})$-, or $R_4$ and $R_5$ together are -$Si(R_3)_2$-$CH_2CH_2$-$Si(R_3)_2$-, Y is -CO-, -CS-, -COO-, -$CON(R_{14})$-, -$SO_2$-, -$SO_2N(R_{14})$- or -$Si(R_3)_2$-, $R_6$ is $C_4$-$C_{20}$alkyl, $C_2$-$C_{20}$alkaryl, $C_4$-$C_{10}$cycloalkyl, $C_5$-$C_{20}$cycloalkylalkyl, $C_5$-$C_{20}$alkylcycloalkyl, $C_6$-$C_{20}$alkylcycloalkylalkyl, $C_6$-$C_{14}$aryl, $C_7$-$C_{20}$aralkyl, $C_7$-$C_{20}$alkaryl or $C_8$-$C_{20}$alkarylalkyl, it being possible for these radicals to be unsubstituted or substituted by $C_1$-$C_{18}$alkoxy, $C_1$-$C_{18}$alkylthio or halogen, or $R_6$ and $R_4$ together are $C_4$-$C_8$alkylene, which may be interrupted by -O-, -S- or -$N(R_{14})$-, with

the proviso that the C atom of $R_6$ which is adjacent to Y does not carry an H atom if Y is -CO-, -CS- or $-SO_2-$, $R_7$, $R_6$, $R_9$ and $R_{10}$, independently of one another, are hydrogen, $C_1$-$C_{18}$alkyl, $C_2$-$C_5$alkenyl, $C_7$-$C_9$phenylalkyl or $C_7$-$C_{12}$alkylphenyl, each of which is unsubstituted or substituted by $C_2$-$C_8$dialkylamino, bis[2-($C_1$-$C_4$alkoxy)ethyl]amino, morpholino, piperidino, $C_2$-$C_{12}$alkoxy, $-(OCH_2CH_2)_p-O-C_1-C_{12}$alkyl where p = 1-20, 1,3-dioxolan-2-yl, $C_1$-$C_{12}$alkylthio or halogen, or are 2-furyl or $-Si(R_3)_3$, $R_{11}$ is $C_1$-$C_{12}$alkyl which is unsubstituted or substituted by halogen, $C_1$-$C_{12}$alkoxy or $C_2$-$C_8$dialkylamino, or $C_6$-$C_{14}$aryl, $C_7$-$C_{20}$aralkyl, $C_7$-$C_{20}$alkaryl or $C_8$-$C_{20}$alkarylalkyl, each of which is unsubstituted or substituted by $C_1$-$C_8$alkoxy, $-(OCH_2CH_2)_p-O-C_1-C_{12}$alkyl where p = 1-20, $C_1$-$C_8$alkylthio, $C_2$-$C_8$dialkylamino, halogen or nitro, $R_{12}$ is hydrogen or has one of the meanings given for $R_{11}$, $R_{13}$ is $C_1$-$C_{18}$alkyl, $C_3$-$C_{12}$cycloalkyl, $C_2$-$C_5$alkenyl, glycidyl, $-(CH_2CH_2O)_p-C_1-C_{12}$alkyl where p = 1-20, $C_6$-$C_{10}$aryl, $C_7$-$C_{20}$aralkyl, $C_7$-$C_{20}$alkaryl or $C_8$-$C_{20}$alkarylalkyl, it being possible for the aryl radicals to be substituted by $C_1$-$C_4$alkoxy, $C_1$-$C_4$alkylthio, $C_2$-$C_8$dialkylamino, halogen or nitro, or $R_{13}$ is $C_1$-$C_{20}$haloalkyl, $-Si(R_3)_3$, $-Sn(R_3)_3$ or 2-tetrahydropyranyl, and $R_{14}$ is $C_1$-$C_{12}$alkyl, $C_3$-$C_5$alkaryl or $C_7$-$C_9$phenylalkyl, by reacting a compound of the formula VIII

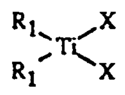

VIII

in which X is Cl, Br or I, with $LiR_2$, which comprises reacting a mixture of 1 mole-equivalent of the compound of the formula VIII and 2 mole-equivalents of a compound $HR_2$ with 2 to 2.5 mole-equivalents of a lithium amide at -30°C to +25°C in an inert solvent and isolating the titanocene in a conventional manner after separating off the LiX formed, the lithium amide being a compound of the formula $LiN(R_{15})(R_{16})$, in which $R_{15}$ and $R_{16}$, independently of one another, are 1-branched alkyl, cyclohexyl or phenyl, or $R_{15}$ and $R_{16}$, together with the N atom, are a 2,5-dialkylated pyrrolidine or a 2,6-dialkylated or 2,2,6,6-tetraalkylated piperidine.

2. A process according to claim 1, wherein 2.0 to 2.2 mole-equivalents of the lithium amide are used per mole-equivalent of the compound of the formula VIII.

3. A process according to claim 1, wherein the reaction is carried out in the presence of a polar solvent or, if appropriate, in a mixture of polar and non-polar solvents.

4. A process according to claim 1, wherein a compound of the formula VIII is used in which X is chlorine.

5. A process according to claim 1, wherein the lithium amide used is lithium diisopropylamide, lithium cyclohexylisopropylamide, lithium dicyclohexylamide or lithium 2,2,6,6-tetramethylpiperidide, in particular lithium diisopropylamide.

6. A process according to claim 1, wherein $R_1$ is cyclopentadienyl$^{\ominus}$ or $C_1$-$C_4$alkyl-substituted cyclopentadienyl$^{\ominus}$, in particular methylcyclopentadienyl$^{\ominus}$.

7. A process according to claim 1, wherein $R_2$ is a monovalent radical of the formula IX

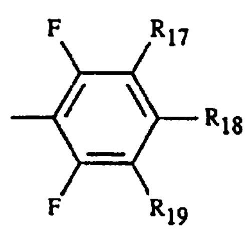

IX

in which $R_{17}$, $R_{18}$ and $R_{19}$, independently of one another, are hydrogen, fluorine, $C_1$-$C_4$alkyl or a group of the formula III-VII.

8. A process according to claim 7, wherein, in the formula IX, $R_{17}$ or $R_{18}$ is a group of the formula III-VII, and the other radicals $R_{17}$, $R_{18}$ and $R_{19}$ are hydrogen or fluorine.

**9.** A process according to claim 8, wherein $R_{17}$ or $R_{18}$ is a group of the formula III-VII in which n is 0 or 1, $R_4$ is $C_1$-$C_{12}$alkyl, $C_3$-$C_{12}$alkoxy, phenyl, $C_7$-$C_9$phenylalkyl, cycloalkyl, cyclohexylmethyl or a $-(CH_2CH_2O)_p$-$C_1$-$C_4$alkyl group where p = 1-5, $R_5$ has one of the meanings given for $R_4$, or $R_4$ and $R_5$ together are $C_4$-$C_5$alkylene, which may be interrupted by -O- or $-N(R_{14})$- where $R_{14}$ is $C_1$-$C_4$alkyl, Y is -CO-, $-SO_2$- or -COO-, $R_6$ is $C_4$-$C_{12}$alkyl, phenyl, or $CH_3$-, $CH_3O$- or Cl-substituted phenyl or $C_1$-$C_8$haloalkyl, or $R_5$ and $R_4$ together are $C_4$-$C_8$alkylene, with the proviso that the C atom of $R_5$ which is adjacent to Y does not carry an H atom, $R_7$, $R_5$, $R_9$ and $R_{10}$, independently of one another, are hydrogen, $C_1$-$C_8$alkyl, $C_2$-$C_{12}$alkoxyalkyl, $C_2$-$C_4$alkenyl, phenyl or 2-furyl, $R_{11}$ is phenyl which is unsubstituted or substituted by $C_1$-$C_{12}$alkyl, $C_1$-$C_4$alkoxy, $C_1$-$C_4$alkylthio, halogen or nitro, $R_{12}$ is hydrogen, and $R_{13}$ is $C_1$-$C_{14}$alkyl, $-(CH_2CH_2O)_p$-$C_1$-$C_{12}$alkyl where p = 1-20, phenyl, benzyl, 2-tetrahydropyranyl or $-Si(CH_3)_3$.

**10.** A process for the preparation of a titanocene of the formula X

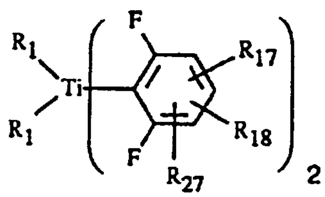

(X),

in which $R_1$ is cyclopentadienyl$^{\ominus}$, indenyl$^{\ominus}$ or 4,5,6,7-tetrahydroindenyl$^{\ominus}$, each of which is unsubstituted or monosubstituted or polysubstituted by $C_1$-$C_{18}$alkyl, $C_1$-$C_{18}$alkoxy, $C_2$-$C_{18}$alkenyl, $C_5$-$C_8$cycloalkyl, $C_6$-$C_{10}$aryl, $C_7$-$C_{16}$aralkyl, $-Si(R_3)_3$, $-Ge(R_3)_3$ or halogen, or the two $R_1$ radicals together are a divalent radical of the formula II

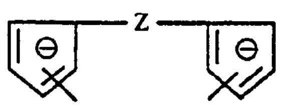

II

in which Z is $-(CH_2)_m$- where m = 1, 2 or 3, unsubstituted or phenyl-substituted $C_2$-$C_{12}$alkylidene, $-Si(R_3)_2$- or $-Si(R_3)_2$-O-$Si(R_3)_2$-, and $R_3$ is $C_1$-$C_{12}$alkyl or $C_6$-$C_{10}$aryl, $R_{17}$ and $R_{18}$, independently of one another, are hydrogen, fluorine or $C_1$-$C_4$alkyl, and $R_{27}$ is $-NH_2$ or a group of the formula XI or XIa

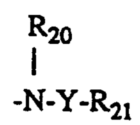

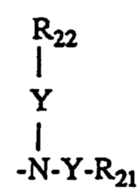

(XI) (XIa)

in which $R_{20}$ is hydrogen, linear or branched $C_1$-$C_{20}$alkyl, $C_2$-$C_{20}$alkenyl, $C_3$-$C_8$cycloalkyl, $C_4$-$C_{20}$cycloalkylalkyl or -alkylcycloalkyl, $C_5$-$C_{20}$alkylcycloalkylalkyl, $C_6$-$C_{20}$cycloalkenylalkyl, $C_6$-$C_{14}$aryl, $C_7$-$C_{20}$aralkyl or -alkaryl, $C_8$-$C_{20}$alkaralkyl or $C_3$-$C_{12}$trialkylsilyl, these radicals being unsubstituted or substituted by $C_1$-$C_{18}$alkoxy, $C_1$-$C_{18}$alkylthio, $C_1$-$C_{18}$alkylsulfonyl, $C_6$-$C_{10}$arylsulfonyl, $C_7$-$C_{20}$alkarylsulfonyl, 2-tetrahydrofuryl or cyano, $R_{21}$ has one of the meanings given for $R_{20}$ or is $C_1$-$C_{20}$haloalkyl, $C_2$-$C_{20}$alkyl which is interrupted by -CO- or $C_1$-$C_{12}$alkyl which is substituted by -COOH or $-COOR_{23}$, in which $R_{23}$ is $C_1$-$C_{12}$alkyl, $C_5$-$C_{12}$cycloalkyl, $C_6$-$C_{16}$aryl or $C_7$-$C_{16}$aralkyl, and, in the case where Y is -CO-, -CS- or $-SO_2$-, may alternatively be $-NR_{24}R_{25}$ in which $R_{24}$ and $R_{25}$, independently of one another, have one of the meanings given for $R_{20}$, or $R_{24}$ and $R_{25}$ together are $C_3$-$C_7$alkylene, which may be interrupted by -O-, -S- or $-N(R_{26})$- in which $R_{26}$ is hydrogen, $C_1$-$C_{12}$alkyl, $C_3$-$C_{12}$alkenyl, $C_7$-$C_{12}$aralkyl or $C_2$-$C_{20}$alkanoyl, or $R_{20}$ and $R_{21}$ together are linear or branched $C_2$-$C_8$alkylene, $C_2$-$C_8$alkylene which is substituted by halogen, $C_1$-$C_4$alkoxy, allyloxy or $-NR_{24}R_{25}$, or are a divalent radical of the formula

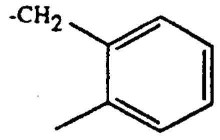 or 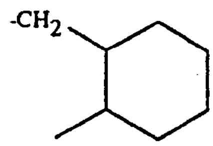 or 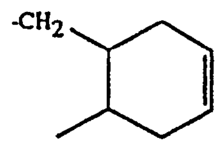

or $-Y-R_{21}$ is $R_{20}$ with the exception of hydrogen, Y is a -CO-, -CS-, -COO-, $-SO_2-$ or $-Si(R_{23})_2-$ group, in which $R_{23}$ is as defined above, $R_{22}$ has one of the meanings given for $R_{21}$, or $R_{22}$ and $R_{21}$ together are $C_1$-$C_8$alkanediyl, $C_2$-$C_8$alkenediyl, $C_6$-$C_{14}$arenediyl, $C_4$-$C_{12}$cycloalkanediyl, $C_5$-$C_{12}$cycloalkenediyl, $C_6$-$C_{14}$cycloalkadienediyl, $C_7$-$C_{20}$bicycloalkanediyl, $C_7$-$C_{20}$bicycloalkenediyl or $C_2$-$C_4$alkanediyl which is interrupted by -O-, -S- or $-N(R_{26})-$, these radicals being unsubstituted or substituted by one or more of the substituents halogen, $C_1$-$C_{10}$alkoxy, $C_1$-$C_{20}$alkyl, $C_3$-$C_{20}$alkenyl or $C_6$-$C_{14}$aryl, which comprises reacting 1 mole-equivalent of a compound of the formula $(R_1)_2TiX_2$, in which $R_1$ is as defined above and X is Cl, Br or I, and 2 mole-equivalents of an azomethine of the formula XII

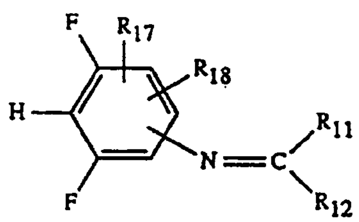

(XII),

in which $R_{11}$ is $C_1$-$C_{12}$alkyl which is unsubstituted or substituted by halogen, $C_1$-$C_{12}$alkoxy or $C_2$-$C_8$dialkylamino, or $C_8$-$C_{14}$aryl, $C_7$-$C_{20}$aralkyl, $C_7$-$C_{20}$alkaryl or $C_8$-$C_{20}$alkarylalkyl, each of which is unsubstituted or substituted by $C_1$-$C_8$alkoxy, $-(OCH_2CH_2)_p-O-C_1-C_{12}$alkyl where p = 1-20, $C_1$-$C_8$alkylthio, $C_2$-$C_8$dialkylamino, halogen or nitro, and $R_{12}$ is hydrogen or has one of the meanings given for $R_{11}$, with 2 to 2.5 mole-equivalents of a lithium amide of the formula $LiN(R_{15})(R_{16})$ in which $R_{15}$ and $R_{16}$ are as defined in claim 1, at -30°C to 25°C in an inert solvent to give a titanocene of the formula XIII

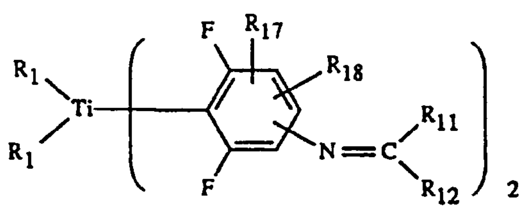

(XIII),

in which $R_{17}$, $R_{18}$, $R_{11}$ and $R_{12}$ are as defined above, hydrolysing the latter, and, if desired, converting the resultant $NH_2$ product of the formula

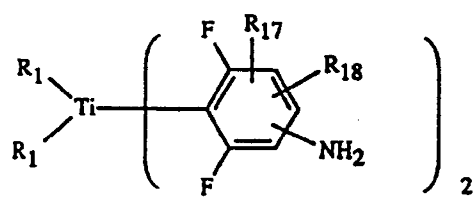

(XIV)

into the compound of the formula X by known alkylation and acylation methods.

## Revendications

1. Procédé pour la préparation de titanocènes de formule I

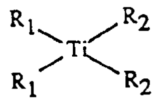

I

dans laquelle $R_1$ signifie un 4,5,6,7-tétrahydroindényle$^{\ominus}$, un indényle$^{\ominus}$ ou un cyclopentadiényle$^{\ominus}$ non substitué ou substitué une ou plusieurs fois par les alkyle en $C_1$-$C_{18}$, alcoxy en $C_1$-$C_{18}$, alcènyle en $C_2$-$C_{18}$, cycloalkyle en $C_5$-$C_8$, aryle en $C_6$-$C_{10}$, aralkyle en $C_7$-$C_{16}$, -Si$(R_3)_4$, -Ge$(R_3)_4$ ou halogène, ou les deux $R_1$ ensemble représentent un radical bivalent de formule II

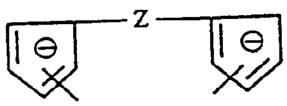

II

dans laquelle Z-$(CH_2)_m$- avec m = 1, 2 ou 3 signifie un alkylidène en $C_2$-$C_{12}$ éventuellement substitué par un phényle, -Si$(R_3)_2$- ou Si$(R_3)_2$-O-Si$(R_3)_2$- et
$R_3$ signifie les alkyle en $C_1$-$C_{12}$ ou aryle en $C_6$-$C_{10}$,
$R_2$ signifie un cycle de phényle pouvant être susbstitué dans les deux positions ortho par rapport à la liaison Ti-C par le fluor et pouvant en outre être substitué par d'autres atomes de fluor, par des alkyle en $C_1$-$C_4$ ou des groupes de formules III à VII

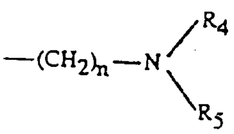 III, 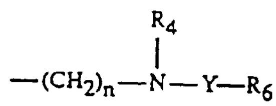 IV, 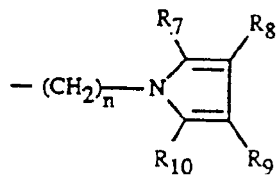 V,

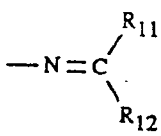 VI,

-O-$R_{13}$ VII

où n représente un nombre entier de zéro à 6,
$R_4$ signifie les alkyle en $C_1$-$C_{20}$, cycloalkyle en $C_3$-$C_{10}$, cycloalkylalkyle en $C_4$-$C_{20}$, alkylcycloalkyle en $C_4$-$C_{20}$, alkylcycloalkylalkyle en $C_5$-$C_{20}$, aryle en $C_6$-$C_{14}$, aralkyle en $C_7$-$C_{20}$, alcaryle en $C_7$-$C_{20}$, alcaralkyle en $C_8$-$C_{20}$, alcoxyalkyle en $C_3$-$C_{12}$, le tétrahydrofurfuryle ou un radical -$(CH_2CH_2O)_p$-(alkyle en $C_1$-$C_{12}$) avec p = 1 - 20,
$R_5$ a l'une des significations données pour $R_4$, ou $R_4$ et $R_5$ ensemble signifient un alkylène en $C_3$-$C_8$, qui peut être interrompu par -O-, -S- ou -N$(R_{14})$-, ou $R_4$ et $R_5$ ensemble représentent -Si$(R_3)_2$-$CH_2CH_2$-Si$(R_3)_2$-,
Y représente -CO-, -CS-, -COO-, -CON$(R_{14})$-, -$SO_2$-, -$SO_2$N$(R_{14})$- ou -Si$(R_3)_2$-,
$R_6$ représente les alkyle en $C_4$-$C_{20}$, alcaryle en $C_2$-$C_{20}$, cycloalkyle en $C_4$-$C_{10}$, cycloalkylalkyle en $C_5$-$C_{20}$, alkylcycloalkyle en $C_5$-$C_{20}$, alkylcycloalkylalkyle en $C_6$-$C_{20}$, aryle en $C_6$-$C_{14}$, aralkyle en $C_7$-$C_{20}$, alcaryle en $C_7$-$C_{20}$ ou alcarylalkyle en $C_8$-$C_{20}$, ces radicaux pouvant être non substitués ou substitués par des alcoxy en $C_1$-$C_{18}$, alkylthio en $C_1$-$C_{18}$ ou halogène,
ou $R_6$ et $R_4$ ensemble signifient un alkylène en $C_4$-$C_8$ qui peut être interrompu par -O-, -S- ou -N$(R_{14})$-, à la condition que l'atome de carbone du $R_6$ voisin de Y ne porte pas d'atomes d'hydrogène, lorsque Y est -CO-, -CS- ou -$SO_2$-,
$R_7$, $R_8$, $R_9$ et $R_{10}$ indépendamment l'un de l'autre signifient l'hydrogène, les alkylphényle en $C_7$-$C_{12}$, phénylalkyle en $C_7$-$C_9$, alcènyle en $C_2$-$C_5$, alkyle en $C_1$-$C_{18}$ non substitués ou substitués par les dialkylamino en $C_2$-$C_8$, bis [2-(alcoxy en $C_1$-$C_4$)-éthyl]amino, morpholino, pipéridino, alcoxy en $C_2$-$C_{12}$, -$(OCH_2CH_2)_p$-O-(alkyle en $C_1$-$C_{12}$) avec p = 1-20, 1,3-dioxolanne-2-yle, alkylthio en $C_1$-$C_{12}$ ou halogène, ou représentent le 2-furyle ou -Si$(R_3)_3$,
$R_{11}$ représente les alkyle en $C_1$-$C_{12}$ non substitué ou substitué par des halogène, alcoxy en $C_1$-$C_{12}$ ou dialkylamino en $C_2$-$C_8$, alcaryle en $C_7$-$C_{20}$, aralkyle en $C_7$-$C_{20}$ ou aryle en $C_6$-$C_{14}$ non substitué ou subs-

titué par des alcoxy en $C_1$-$C_8$, $-(OCH_2CH_2)_p$-O-(alkyle en $C_1$-$C_{12}$) avec p = 1-20, alkylthio en $C_1$-$C_8$, dialkylamino en $C_2$-$C_8$, halogène ou nitro,
$R_{12}$ est l'hydrogène ou a l'une des significations données pour $R_{11}$,
$R_{13}$ représente les alkyle en $C_1$-$C_{18}$, cycloalkyle en $C_3$-$C_{12}$, alcènyle en $C_2$-$C_5$, glycidyle, $-(CH_2CH_2O)_p$-(alkyle en $C_1$-$C_{12}$)avec p = 1-20, aryle en $C_6$-$C_{10}$, aralkyle en $C_7$-$C_{20}$, alcaryle en $C_7$-$C_{20}$, alcarylalkyle en $C_8$-$C_{20}$, les radicaux aryle pouvant être substitués par des alcoxy en $C_1$-$C_4$, alkylthio en $C_1$-$C_4$, dialkylamino en $C_2$-$C_8$, halogène ou nitro, ou $R_{13}$ signifie un halogéno-alkyle en $C_1$-$C_{20}$, $-Si(R_3)_3$, $-Sn(R_3)_3$ ou le 2-tétrahydropyranyle et
$R_{14}$ signifie les alkyle en $C_1$-$C_{12}$, alcaryle en $C_3$-$C_5$ ou phénylalkyle en $C_7$-$C_9$, par réaction du composé de formule VIII

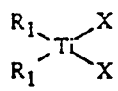

VIII

dans laquelle X signifie Cl, Br ou J, avec $LiR_2$, caractérisé en ce qu'on fait réagir un mélange de 1 mole-équivalent du composé de formule VIII et de 2 moles-équivalents d'un composé $HR_2$ avec 2 à 2,5 moles-équivalents d'un amidure de lithium à des températures de -30°C à +25°C dans un solvant inerte et, après avoir séparé le LiX formé, on isole le titanocène de façon usuelle,

l'amidure de lithium étant un composé de formule $LiN(R_{15})(R_{16})$, où $R_{15}$ et $R_{16}$ indépendamment l'un de l'autre signifient un phényle, un cyclohexyle ou un alkyle ramifié en position 1, ou $R_{15}$ et $R_{16}$ ensemble avec l'atome de N signifient une pyrrolidine dialkylée en positions 2,5 ou une pipéridine dialkylée en positions 2,6 ou tétraalkylée en positions 2,2,6,6.

**2.** Procédé selon la revendication 1, caractérisé en ce que pour 1 mole-équivalent de composé de formule VIII, on utilise 2,0 à 2,2 moles-équivalents d'amidure de lithium.

**3.** Procédé selon la revendication 1, caractérisé en ce qu'on réalise la réaction en présence d'un solvant polaire ou éventuellement dans un mélange de solvants polaires et non polaires.

**4.** Procédé selon la revendication 1, caractérisé en ce qu'on utilise un composé de formule VIII, dans laquelle X est le chlore.

**5.** Procédé selon la revendication 1, caractérisé en ce qu'on utilise en tant qu'amidure de lithium le diisopropylamidure de lithium, le cyclohexylisopropylamidure de lithium, le dicyclohexylamidure de lithium ou le 2,2,6,6-tétraméthylpipéridide de lithium, plus particulièrement le diisopropylamidure de lithium.

**6.** Procédé selon la revendication 1, caractérisé en ce que $R_1$ signifie le cyclopentadiényle$^{\ominus}$ ou un cyclopentadiényle$^{\ominus}$ substitué par un alkyle en $C_1$-$C_4$, plus particulièrement le méthylcyclopentadiényle$^{\ominus}$.

**7.** Procédé selon la revendication 1, caractérisé en ce que $R_2$ est un radical monovalent de formule IX

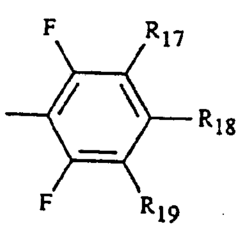

IX

dans laquelle $R_{17}$, $R_{18}$ et $R_{19}$ indépendamment l'un de l'autre signifient l'hydrogène, le fluor, un alkyle en $C_1$-$C_4$ ou un groupe de formules III à VII.

**8.** Procédé selon la revendication 7, caractérisé en ce que dans la formule IX $R_{17}$ ou $R_{18}$ signifient un groupe de formules III à VII et les autres radicaux $R_{17}$, $R_{18}$ et $R_{19}$ signifient l'hydrogène ou le fluor.

**9.** Procédé selon la revendication 8, caractérisé en ce que $R_{17}$ ou $R_{18}$ sont un groupe de formules III à VII où n est 0 ou 1,

$R_4$ signifie les alkyle en $C_1$-$C_{12}$, alcoxy en $C_3$-$C_{12}$, phényle, phénylalkyle en $C_7$-$C_9$, cycloalkyle, cyclohexylméthyle ou un groupe -$(CH_2CH_2O)_p$-(alkyle en $C_1$-$C_4$) avec p = 1-5,
$R_5$ a l'une des significations données pour $R_4$, ou $R_4$ et $R_5$ ensemble signifient un alkylène en $C_4$-$C_5$, qui peut être interrompu par -O- ou -N($R_{14}$)-, $R_{14}$ signifiant un alkyle en $C_1$-$C_4$,
Y signifie -CO-, -$SO_2$- ou -COO-,
$R_6$ signifie les alkyle en $C_4$-$C_{12}$, phényle ou phényle substitué par $CH_3$, $CH_3O$ ou Cl, ou halogéno-alkyle en $C_1$-$C_8$, ou $R_6$ et $R_4$ ensemble signifient un alkylène en $C_4$-$C_8$, à la condition que l'atome de carbone du $R_6$ voisin de Y ne porte pas d'atomes de H,
$R_7$, $R_8$, $R_9$ et $R_{10}$ indépendamment l'un de l'autre signifient l'hydrogène, les alkyle en $C_1$-$C_8$, alcoxyalkyle en $C_2$-$C_{12}$, alcènyle en $C_2$-$C_4$, phényle ou le 2-furyle,
$R_{11}$ signifie un phényle non substitué ou substitué par des alkyle en $C_1$-$C_{12}$, alcoxy en $C_1$-$C_4$, alkylthio en $C_1$-$C_4$, halogène ou nitro, $R_{12}$ est l'hydrogène, et
$R_{13}$ signifie un alkyle en $C_1$-$C_{14}$, -$(CH_2CH_2O)_p$-(alkyle en $C_1$-$C_{12}$) avec p = 1-20, un phényle, un benzyle, le 2-tétrahydropyranyle ou -$Si(CH_3)_3$.

**10.** Procédé pour la préparation de titanocènes de formule X

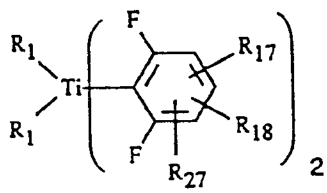

X

dans laquelle $R_1$ représente un 4,5,6,7-tétrahydroindényle$^{\ominus}$, un indényle$^{\ominus}$ ou un cyclopentadiényle$^{\ominus}$ non substitué ou substitué une ou plusieurs fois par des alkyle en $C_1$-$C_{18}$, alcoxy en $C_1$-$C_{18}$, alcènyle en $C_2$-$C_{18}$, cycloalkyle en $C_5$-$C_8$, aryle en $C_6$-$C_{10}$, aralkyle en $C_7$-$C_{16}$, -$Si(R_3)_4$, -$Ge(R_3)_4$ ou halogène, ou les deux $R_1$ ensemble signifient un radical bivalent de formule II

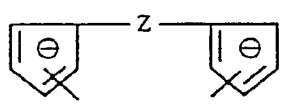

II

où Z-$(CH_2)_m$ avec m = 1, 2 ou 3, signifie un alkylydène en $C_2$-$C_{12}$ éventuellement substitué par un phényle, -$Si(R_3)_2$- ou -$Si(R_3)_2$-O-$Si(R_3)_2$- et
$R_3$ signifie un alkyle en $C_1$-$C_{12}$ ou un aryle en $C_6$-$C_{10}$, $R_{17}$ et $R_{18}$ indépendamment l'un de l'autre signifient l'hydrogène, le fluor ou un alkyle en $C_1$-$C_4$, et $R_{27}$ représente -$NH_2$ ou un groupe de formule XI ou XIa

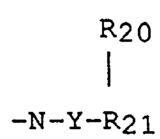

(XI)

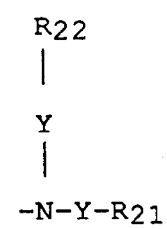

(XIa)

dans lesquelles $R_{20}$ représente l'hydrogène, les trialkylsilyle en $C_3$-$C_{12}$, alcaralkyle en $C_8$-$C_{20}$ aralkyle ou alcaryle en $C_7$-$C_{20}$, aryle en $C_6$-$C_{14}$, cycloalcènylalkyle en $C_6$-$C_{20}$, alkylcycloalkylalkyle en $C_5$-$C_{20}$, cycloalkylalkyle ou alkylcyclo-alkyle en $C_4$-$C_{20}$, cyclo-alkyle en $C_3$-$C_8$, alcènyle en $C_2$-$C_{20}$, alkyle en $C_1$-$C_{20}$ linéaire ou ramifié, ces radicaux étant non substitués ou substitués par des alcoxy en $C_1$-$C_{18}$, alkylthio en $C_1$-$C_{18}$, alkylsulfonyle en $C_1$-$C_{18}$, arylsulfonyle en $C_6$-$C_{10}$, alcarylsulfonyle en $C_7$-$C_{20}$, le 2-tétrahydrofuranyle ou un cyano,

$R_{21}$ a l'une des significations données pour $R_{20}$ ou est un halogéno-alkyle en $C_1$-$C_{20}$, un alkyle en $C_2$-$C_{20}$ interrompu par -CO- ou un alkyle en $C_1$-$C_{12}$ substitué par -COOH ou -COOH$R_{23}$, où $R_{23}$ représente les alkyle en $C_1$-$C_{12}$, cycloalkyle en $C_5$-$C_{12}$, aryle en $C_6$-$C_{16}$ ou aralkyle en $C_7$-$C_{16}$ et, dans le cas où Y est -CO-, -CS- ou -$SO_2$-, peut aussi signifier -$NR_{24}R_{25}$, où $R_{24}$ et $R_{25}$ indépendamment l'un de l'autre ont l'une des significations données pour $R_{20}$, ou $R_{24}$ et $R_{25}$ ensemble signifient un alkylène en $C_3$-$C_7$, qui peut être interrompu par -O-, -S- ou -N($R_{26}$)-, où $R_{26}$ signifie l'hydrogène, les alkyle en $C_1$-$C_{12}$, alcènyle en $C_3$-$C_{12}$, aralkyle en $C_7$-$C_{12}$ ou alcanoyle en $C_2$-$C_{20}$, ou $R_{20}$ et $R_{21}$ ensemble représentent les alkylène en $C_2$-$C_8$ substitué par des halogène, alcoxy en $C_1$-$C_4$, allyloxy ou -$NR_{24}R_{25}$ ou alkylène en $C_2$-$C_8$ linéaire ou ramifié, ou représentent un radical bivalent de formule

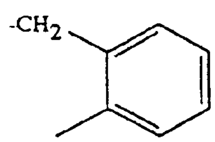
ou
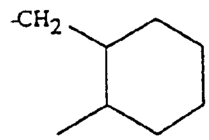
ou
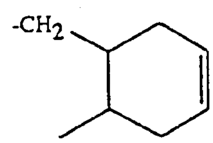

ou -Y-$R_{21}$ représente $R_{20}$ à l'exception de l'hydrogène Y signifie un groupe -CO-, -CS-, -COO-, -$SO_2$- ou -Si($R_{23}$)$_2$-, où $R_{23}$ a la signification donnée auparavant,
$R_{22}$ a l'une des significations données pour $R_{21}$, ou
$R_{22}$ et $R_{21}$ ensemble représentent les alcanediyle en $C_1$-$C_8$, alcènediyle en $C_2$-$C_8$, arènediyle en $C_6$-$C_{14}$, cycloalcanediyle en $C_4$-$C_{12}$, cycloalcènediyle en $C_5$-$C_{12}$, cycloalcadiènediyle en $C_6$-$C_{14}$, bicycloalcanediyle en $C_7$-$C_{20}$, bicycloalcène-diyle en $C_7$-$C_{20}$ ou alcanediyle en $C_2$-$C_4$ interrompu par -O-, -S- ou -N($R_{26}$)-, ces radicaux étant non substitués ou substitués par par un ou plusieurs substituants pris dans le groupe comportant des halogène, alcoxy en $C_1$-$C_{10}$, alkyle en $C_1$-$C_{20}$, alcènyle en $C_3$-$C_{20}$ ou aryle en $C_6$-$C_{14}$, caractérisé en ce qu'on fait réagir 1 mole-équivalent d'un composé de formule $(R_1)_2TiX_2$, où $R_1$ a la signification donnée ci-dessus et X signifie Cl, Br ou J, et 2 moles-équivalents d'une azométhine de formule XII

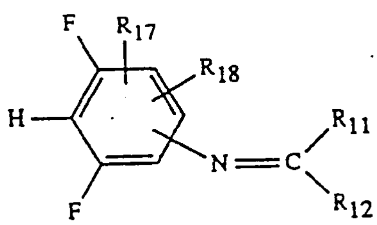

XII

où
$R_{11}$ représente les alkyle en $C_1$-$C_{12}$ non substitué ou substitué par un halogène, par un alcoxy en $C_1$-$C_{12}$ ou par un dialkylamino en $C_2$-$C_8$, alcarylalkyle en $C_8$-$C_{20}$, alcaryle en $C_7$-$C_{20}$, aralkyle en $C_7$-$C_{20}$ ou aryle en $C_6$-$C_{14}$ non substitué ou substitué par des alcoxy en $C_1$-$C_8$, -$(OCH_2CH_2)_p$-O-(alkyle en $C_1$-$C_{12}$) avec p = 1-20, alkylthio en $C_1$-$C_8$, dialkylamino en $C_2$-$C_8$, halogène ou nitro,
$R_{12}$ est l'hydrogène ou a l'une des significations données pour $R_{11}$,
avec 2 à 2,5 moles-équivalents d'un amidure de lithium de formule LiN($R_{15}$)($R_{16}$) où
$R_{15}$ et $R_{16}$ sont définis comme dans la revendication 1, à une température de -30°C à 25°C dans un solvant inerte, en un titanocène de formule XIII

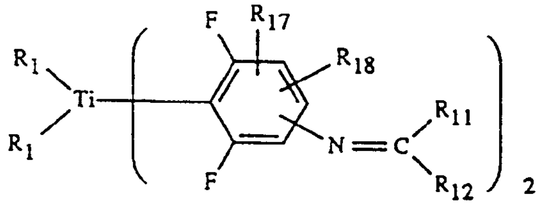

XIII

dans laquelle $R_{17}$, $R_{18}$, $R_{11}$ et $R_{12}$ ont la signification donnée ci-dessus, qu'on hydrolyse ce dernier et qu'on transforme éventuellement le produit $NH_2$ ainsi obtenu de formule

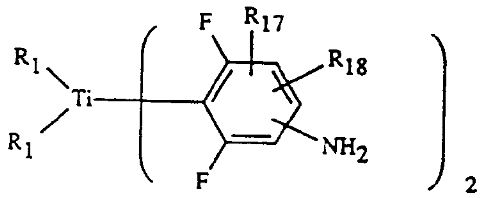

XIV

selon les méthodes d'alkylation et d'acylation connues, en composé de formule X.